(19) Europäisches Patentamt
European Patent Office
Office européen des brevets

(11) EP 0 674 817 B1

(12) EUROPEAN PATENT SPECIFICATION

(45) Date of publication and mention of the grant of the patent:
**03.03.1999 Bulletin 1999/09**

(21) Application number: **94902904.5**

(22) Date of filing: **17.12.1993**

(51) Int Cl.[6]: **H03B 5/00**

(86) International application number:
**PCT/GB93/02594**

(87) International publication number:
**WO 94/15394 (07.07.1994 Gazette 1994/15)**

# (54) LOW POWER ELECTRONIC CIRCUIT COMPRISING A RESONANT SYSTEM AND A FUNCTION CIRCUITRY

ELEKTRONISCHER KLEINLEISTUNGSKREIS MIT EINEM RESONANZSYSTEM UND EINEM FUNKTIONSSCHALTKREIS

CIRCUIT ELECTRONIQUE A FAIBLE PUISSANCE COMPRENANT UN SYSTEME A RESONANCE ET DES CIRCUITS DE FONCTIONS

(84) Designated Contracting States:
**DE FR GB**

(30) Priority: **19.12.1992 GB 9226522**
**03.03.1993 GB 9304248**
**08.07.1993 GB 9314166**

(43) Date of publication of application:
**04.10.1995 Bulletin 1995/40**

(73) Proprietor: **HARVEY, Geoffrey Philip**
**Cambridge CB1 2PD (GB)**

(72) Inventor: **HARVEY, Geoffrey Philip**
**Cambridge CB1 2PD (GB)**

(74) Representative:
**Beresford, Keith Denis Lewis et al**
**BERESFORD & Co.**
**2-5 Warwick Court**
**High Holborn**
**London WC1R 5DJ (GB)**

(56) References cited:
**WO-A-93/04528**
**US-A- 3 593 167**
**US-A- 4 922 210**
**US-A- 5 041 802**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 674 817 B1

Printed by Jouve, 75001 PARIS (FR)

## Description

### FIELD OF THE INVENTION

This invention relates to electronic circuits. More specifically, this invention relates to the reduction of power consumption in electronic circuits.

### BACKGROUND ART

An electronic circuit consumes power in various ways. In particular, power is consumed when input signals to elements of the circuit change state. This power consumption occurs as a result of the charging and discharging of parasitic capacitances associated with the inputs to the circuit elements. Power is not dissipated in the parasitic capacitances themselves but, instead, in the output resistances of earlier circuit elements that furnish the input signals. In modern synchronous integrated circuits ("ICs"), a large portion of the power consumption occurs in clock drivers that provide clock signals to the functional circuit elements.

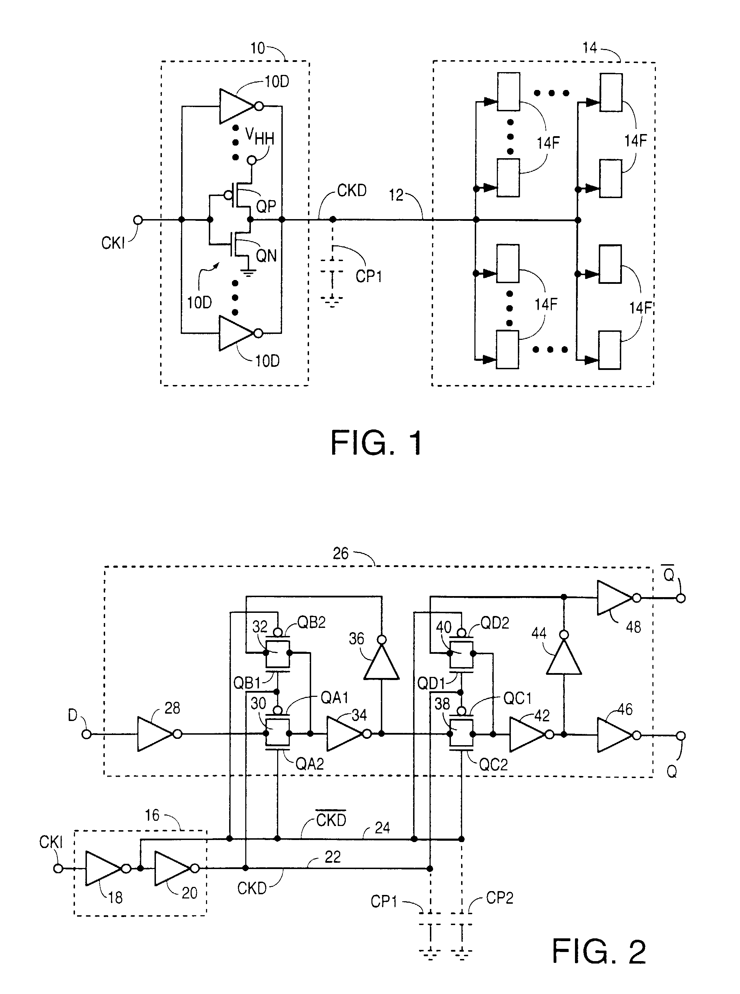

Referring to the drawings, Fig. 1 illustrates a conventional synchronous CMOS IC useful in understanding clock-driver power consumption. The circuit in Fig. 1 contains a clock driver 10 that furnishes a circuit clock signal CKD on a circuit clock line 12 in response to an input clock signal CKI. Clock driver 10 consists of a group of CMOS inverters 10D connected in parallel. Each inverter 10D is formed with a pair of complementary insulated-gate field-effect transistors ("FETS") QN and QP connected in series between circuit ground and a source of a high supply voltage $V_{HH}$.

Clock signal CKD is provided by way of a clock net to the clock inputs of function elements 14F in function circuitry 14. The clock net consists of the lines that branch out from clock line 12 and go to function elements 14F. A parasitic capacitance is associated with the clock input section of each element 14F. The lines that form the clock net also have their own parasitic capacitances.

Function elements 14F are built in proximity to, or contain components connected to, at least one low-impedance source of fixed reference voltage, typically earth or circuit ground potential. The lines that form the clock net are similarly situated in proximity to at least one low-impedance source of fixed reference voltage. To a good approximation, the parasitic capacitances of the clock net lines and the clock inputs to elements 14F can be represented by a single capacitor CP1 connected between clock line 12 and the ground-potential source.

Typically, (a) the clock input resistance of each function element 14F is very high, (b) the propagation delay from driver 10 to the most remote of elements 14F is small compared to clock-frequency period, and (c) the clock-net lines have low resistance and inductance. To a reasonable approximation, the load that clock CKD presents to driver 10 can likewise be represented by capacitor CP1 since it is also connected between the output of driver 10 and the ground-potential source.

Input clock signal CKI switches between a low voltage level, typically ground reference, and a high voltage level, typically $V_{HH}$, at an input clock frequency $f_{CKI}$. During a full clock cycle in which input clock CKI goes from one level to the other level and then back to the first, driver 10 expends an energy equal to $C_{P1}V_{HH}^2$, where $C_{P1}$ is the value of parasitic capacitance CP1. Half of this energy is dissipated as heat by the QP channel resistances when current flows from the $V_{HH}$ supply through FETs QP to charge capacitance CP1 during one half of the clock cycle. The remaining half of energy $C_{P1}V_{HH}^2$ is dissipated as heat by the QN channel resistances when current flows through FETs QN to discharge capacitance CP1 during the other half of the clock cycle.

The number of functional elements 14F in some modern synchronous ICs is very high. As a consequence, parasitic capacitance CP1 is very high. Driver 10 must be quite large in order to charge and discharge capacitance CP1 at the high switching speed typically required. The net result is that driver 10 dissipates a large portion of the power utilized by the IC. For example, the clock driver in the Alpha RISC processor made by Digital Equipment Corporation reportedly consumes about half of the processor power. This is highly disadvantageous.

The IC of Fig. 1 employs only a single circuit clock signal. However, high clock-driver power dissipation also occurs in synchronous prior art ICs that utilize complementary clock signals. Fig. 2 illustrates part of such a complementary-clock circuit.

The circuit of Fig. 2 contains a clock driver 16 formed with inverters 18 and 20 that provide complementary circuit clock signals CKD and $\overline{CKD}$ on circuit clock lines 22 and 24 in response to input clock CKI. Clocks CKD and $\overline{CKD}$ are furnished to a D-type CMOS master-slave flip-flop 26 consisting of a data input buffer, a master portion, a slave portion, and an output buffer. The input buffer, in turn, consists of a CMOS inverter 28 that inverts data signal D and supplies the inverted D signal to the master portion formed with transmission gates 30 and 32 and CMOS inverters 34 and 36. The slave portion consists of transmission gates 38 and 40 and CMOS inverters 42 and 44 that drive the output buffer formed with CMOS inverters 46 and 48. Each transmission gate 30, 32, 38, or 40 consists of a pair of complementary insulated-gate FETs connected in parallel.

Transmission gates 30, 32, 38, and 40 constitute the clock inputs for flip-flop 26. The parasitic capacitances associated with FETs QA1, QB1, QC1, and QD1 of the transmission-gate clock inputs are represented by equivalent parasitic capacitance CP1 associated with line 22. Similarly, the parasitic capacitances associated with FETs QA2, QB2, QC2, and QD2 of the transmission-gate clock inputs are represented by equivalent parasitic capacitance CP2 associated with line 24.

The circuit in Fig. 2 operates as follows. Assume that input clock CKI is initially low so that circuit clock CKD is low and circuit clock $\overline{CKD}$ is high. Gate 30 is conductive, allowing data D to be loaded into the master portion of flip-flop 26. Gate 32 is nonconductive. When input clock CKI goes high so that circuit clocks CKD and $\overline{CKD}$ change state, gate 30 turns off. Gate 32 turns on to latch data D into the master portion. At the same time, gate 38 turns on to allow data D to enter the slave portion. Gate 40 turns off. When input clock CKI returns to its low level, circuit clocks CKD and $\overline{CKD}$ switch back. Gate 38 turns off. Gate 40 turns on to latch data D into the slave portion. Complementary output signals Q and $\overline{Q}$ are then respectively provided at the true and inverted values of data D.

Letting $V_{HH}$ represent the high supply voltage, it turns out that driver 16 dissipates an energy equal to $(C_{P1} + C_{P2})V_{HH}^2$ in one clock cycle, where $C_{P1}$ and $C_{P2}$ are the respective values of parasitic capacitances CP1 and CP2. Consequently, the circuit of Fig. 2 has high clock-driver power dissipation.

High power consumption in the clock-drivers of large state-of-the-art synchronous ICs is a major impediment to future synchronous IC design. It would be extremely desirable to have a mechanism for operating an IC in a synchronous manner without incurring this power penalty.

Resonators are used in certain electronic circuits. For example, Wei et al, U.S. Patent 5,041,802, discloses an oscillator circuit containing a pair of drivers that amplify the output signal of an oscillator formed with a crystal or inductive resonator. One of the drivers is a high-power device utilized to provide high drive during start-up and subsequently turned off. The other driver is a standard low-power device employed during both start-up and steady-state operation. Accordingly, the oscillator circuit has high start-up capability but consumes low power during steady state.

Koulopoulos, U.S. Patent 3,593,167, discloses a self-synchronizing read clock that generates a train of timing pulses in response to a data train consisting of data and synch pulses. The read clock contains a resonant tank circuit which is normally inactive--ie., the tank circuit operates only when externally excited by the pulses in the data train. The resonant frequency of the tank circuit is automatically adjusted in proportion to the phase difference between the pulses in the data and timing trains. As a result, the timing pulses are synchronized with the data and synch pulses.

Mansfield, US Patent 5,325,060, discloses a resonant circuit that may have multiple resonance frequencies and that a square wave can be approximated by combining suitable odd numbered harmonics of a fundamental frequency. However, the problem addressed in Mansfield is that of driving very large electromagnetic coils at audio frequencies in a magnetic resonance imaging (NMR) system.

The circuits of Wei et al, Koulopoulos and Mansfield are of interest. However the resonators in these circuits are not directly utilized for driving digital circuitry so as to significantly reduce power consumption in the clock drivers of synchronous ICs.

## GENERAL DISCLOSURE OF THE INVENTION

The present invention furnishes a resonance technique for driving clock inputs of circuit elements in an electronic circuit that is at least partially synchronous. The parasitic capacitances associated with the clock inputs of the circuit elements and with the lines of the attendant clock net become part of a resonance mechanism. When the parasitic capacitances are discharged, a large part of the energy in the capacitances is transferred to another part of the resonance mechanism for temporary storage rather than being dissipated as heat. The stored energy is subsequently reused. Consequently, the power consumption of an electronic circuit designed according to the invention is much less than that in an otherwise comparable prior art circuit that utilizes a conventional clock driver.

More particularly, the invention provides an electronic circuit comprising:

> a resonant system which, in response to an input clock signal at an input clock frequency, oscillates at a circuit frequency substantially proportional to the input clock frequency to generate a first circuit clock signal at the circuit frequency; and
>
> function circuitry which performs electronic functions in synchronism with the circuit clock signal, clock inputs of the function circuitry receiving the circuit clock signal from a first circuit clock line, the resonant system being operated close to a fundamental resonance frequency such that a resonator in the resonant system is largely in resonance at least with capacitance and/or inductance associated with the circuit clock line and the clock inputs, characterised in that the oscillations of the resonant system include frequency components attributable to the fundamental resonance frequency and at least one resonance frequency of the resonant system other than the fundamental resonance frequency.

In a single-clock implementation, the resonant system typically contains a resonator and a resonance capacitor coupled in series between (a) a circuit clock line on which the circuit clock signal is transmitted and (b) a source of a substantially fixed reference voltage or other voltage at a much lower frequency than the circuit clock frequency. When the parasitic capacitances associated with the clock net and with the clock inputs of elements in the function circuitry are discharged during a half clock cycle, much of the energy in these parasitic capacitances is temporarily transferred to the resonance capacitor. During the next half clock cycle, the energy stored in the resonance capacitor is used to recharge the parasitic capacitances associated with the clock net and clock inputs of the function circuitry.

Alternatively, the resonant system in a single-clock implementation can be formed with a resonator coupled between the circuit clock line and a source of a reference voltage approximately equal to the time-averaged voltage of the circuit clock signal. In this case, the energy in the parasitic capacitances is largely returned to the reference-voltage source.

The invention is readily extended to a complementary-clock implementation in which the resonant system generates a second circuit clock signal substantially inverse to the first circuit clock signal. At least part of the electronic functions of the function circuitry are also performed in synchronism with the second circuit clock signal.

In the complementary-clock implementation, the resonant system typically contains a resonator coupled between a pair of circuit clock lines on which the circuit clock signals are respectively transmitted. When the parasitic capacitances associated with the clock inputs driven from one of the circuit clock signals are discharged during a half clock cycle, much of the energy in these parasitic capacitances is transferred through the resonator to charge the parasitic capacitances associated with the clock inputs driven from the other circuit clock signal. The opposite occurs during the next half clock cycle.

The resonator in both implementations typically contains a main inductive device formed with an inductor or a group of inductors coupled to one another in series. When the resonator is implemented solely with such an inductive device, the fundamental resonance frequency is approximately equal to $1/2\pi\sqrt{L_EC_T}$ where $L_E$ is the inductance of the main inductive device, and $C_T$ is the series equivalent capacitance of all capacitors (both parasitic and real) in parallel with the main inductive device. The waveform of each circuit clock then approximates a sinusoid--i.e., a sine or cosine wave.

It is noted that US 4654605 discloses a clocking arrangement for an analogue shift register. Purely sinusoidal clocking signals are employed instead of square waves, because "this has the advantage that the power dissipation of each clocking circuit is reduced by about the factor 17". The sinusoidal clocking waveform is generated by resonance. In contrast, the resonator of the present invention is provided with additional elements so that each circuit clock waveform contains components attributable to one or more resonance frequencies beside the fundamental frequency. For example, the resonator may also contain (a) one or more inductive-capacitive arrangements coupled in parallel with part or all of the main inductive device or/and (b) one or more capacitors coupled to internal points of the main inductive device. As a result, the waveform for each circuit clock can approach various non-sinusoid shapes such as the square-wave shape desirable for the clock inputs of edge-triggered flip-flops and other level-sensitive elements.

The resonant system preferably includes control circuitry for adjusting the resonance frequency. This typically involves changing inductance and/or capacitance values. Also, the resonant system normally includes a driver that provides a small amount of energy to compensate for energy dissipated as heat due to non-idealities in certain parts of the circuit.

By reusing the energy stored in the parasitic capacitances associated with the clock net and clock inputs of the function circuitry, the power needed for these items is small compared to the power dissipated as heat in the transistors of a conventional clock driver. In particular, the invention reduces clock power consumption at least 50% and often much more. When the present circuit is implemented in IC form, the invention commonly reduces chip area because the resonant system occupies less space than a conventional large clock driver.

While the principles of the invention are particularly applicable to circuit clocking, these principles apply to other situations in which there are repetitive signals. An embodiment of the present invention also provides an electronic circuit wherein the function circuitry includes at least one circuit element containing state circuitry.

## BRIEF DESCRIPTION OF THE DRAWINGS

Figs. 1 and 2 are circuit diagrams of synchronous prior art electronic circuits that employ clock drivers.

Fig. 3 is a general block diagram of a synchronous electronic circuit that utilizes a resonant system in accordance with the invention.

Fig. 4 is a circuit diagram of a complementary-clock implementation of the synchronous circuit in Fig. 3.

Fig. 5 is a circuit diagram of a resonator employable in the implementations of Figs. 4, 22 - 24, 26, 32, 34 - 37, and 39.

Fig. 6 is a simplified graph of waveforms that arise when the resonator of Fig. 5 is utilized in the complementary-clock implementation of Fig. 4.

Figs. 7 and 8 are partial circuit diagrams of embodiments in which the resonator of Fig. 5 is utilized in the complementary-clock implementation of Fig. 4.

Figs. 9 and 10 are circuit diagrams of resonators employable in the implementations of Figs. 4, 22 - 24, 26, 32, 34 - 37, and 39.

Fig. 11 is a circuit diagram of an embodiment in which the resonator of Fig. 10 is utilized in the complementary-clock implementation of Fig. 4.

Fig. 12 is a simplified graph of waveforms that arise when the resonator of Fig. 10 is utilized in the complementary-clock implementation of Fig. 4.

Fig. 13 is a circuit diagram of a resonator employable in the implementations of Figs. 4, 22 - 24, 26, 32, 34 - 37, and 39.

Fig. 14 is a partial circuit diagram of an embodiment in which the resonator of Fig. 13 is employed in the complementary-clock implementation of Fig. 4.

Fig. 15 is a simplified graph of waveforms that arise in the embodiments of Figs. 14 and 29.

Figs. 16, 17, 18, 19, and 20 are circuit diagrams of resonators employable in the implementations of Figs. 4, 22 - 24, 26, 32, 34 - 37, and 39.

Fig. 21 is a simplified graph of AC current as a function of frequency for the resonators of Figs. 5, 9, 10, 13, and 16 - 20.

Figs. 22 and 23 are circuit diagrams of resonating sections alternatively employable in the complementary-clock implementations of Figs. 4, 37, and 39.

Fig. 24 is a circuit diagram of a control circuit generally employable in the complementary-clock implementation of Fig. 4, specifically in the embodiments of Figs. 7, 8, and 14.

Fig. 25 is a circuit diagram of an embodiment of the phase comparator in Fig. 24.

Fig. 26 is a circuit diagram of a single-clock implementation of the synchronous circuit in Fig. 3.

Fig. 27 is a circuit diagram of an embodiment in which the resonator of Fig. 10 is utilized in the single-clock implementation of Fig. 26.

Fig. 28 is a simplified graph of waveforms that arise when the resonator of Fig. 10 is utilized in the single-clock implementation of Fig. 26.

Fig. 29 is a partial circuit diagram of an embodiment in which the resonator of Fig. 13 is utilized in the single-clock implementation of Fig. 26.

Fig. 30 is a partial circuit diagram of a single-clock implementation of the circuit in Fig. 3.

Fig. 31 is a simplified graph of waveforms that arise in the implementation of Fig. 30.

Fig. 32 is a circuit diagram of a single-clock implementation of the circuit in Fig. 3.

Fig. 33 is a simplified graph of waveforms that arise in the implementation of Fig. 32.

Fig. 34 is a partial circuit diagram of an embodiment of the single-clock implementation in Fig. 32.

Figs. 35 and 36 are circuit diagrams of single-clock implementations of the circuit in Fig. 3.

Fig. 37 is a partial circuit diagram of a variation of the complementary-clock implementation in Fig. 4.

Fig. 38 is a general block diagram of another synchronous electronic circuit that utilizes a resonant system in accordance with the invention.

Fig. 39 is a circuit diagram of an embodiment of the variable-frequency oscillator in Fig. 38.

Fig. 40 is a partial circuit diagram of an implementation of the synchronous circuit in Fig. 3 or 38.

Like reference symbols are employed in the drawings and in the description of the preferred embodiments to represent the same or very similar item or items.

All transistors shown in the drawings are enhancement-mode insulated-gate FETs. Bubbles are placed on the gates of P-channel FETs to distinguish them from N-channel FETs.

## DESCRIPTION OF THE PREFERRED EMBODIMENTS

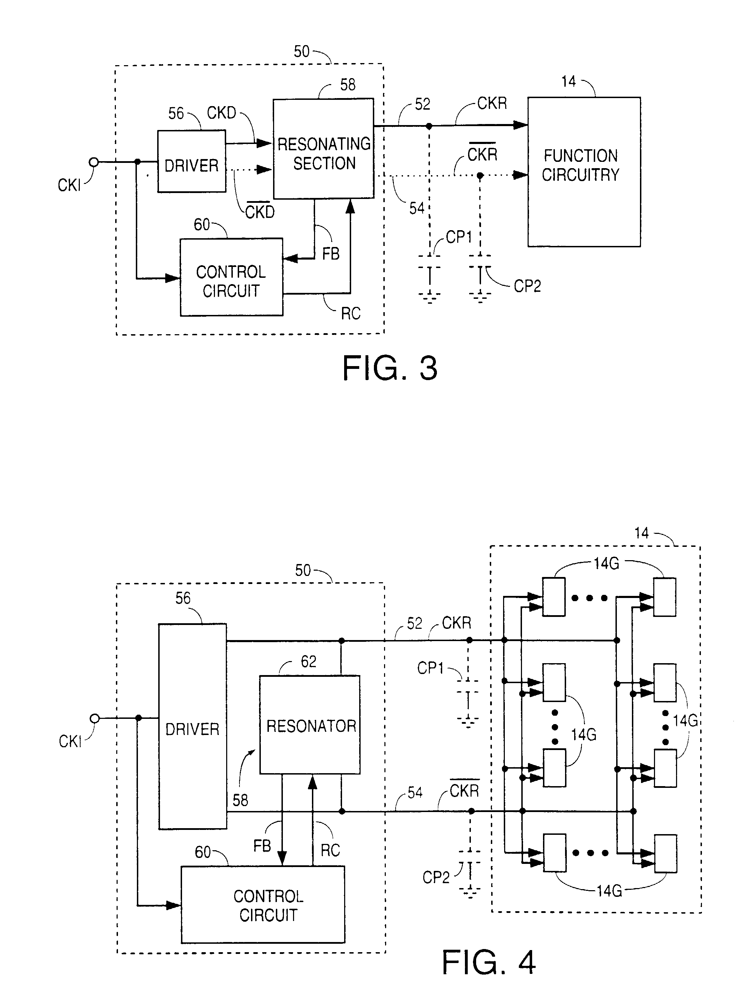

Referring to Fig. 3, it illustrates a general configuration for a synchronous electronic circuit that contains a resonant system 50 for supplying one or more clock signals to function circuitry 14 at low power consumption in accordance with the teachings of the invention. Resonant system 50 oscillates at a circuit clock frequency $f_{CKR}$ in response to input (or reference) clock signal CKI which switches between its low and high values at input clock frequency $f_{CKI}$. Circuit clock frequency $f_{CKR}$ substantially equals $f_{CKI}$.

Resonant system 50 provides a circuit clock signal CKR at circuit clock frequency $f_{CKR}$ to function circuitry 14 along a circuit clock line 52. Circuit clock CKR is largely in phase with, or largely of opposite phase to, input clock CKI. In complementary-clock implementations, system 50 supplies a further circuit clock signal $\overline{CKR}$ at frequency $f_{CKR}$ to circuitry 14 along a circuit clock line 54. Circuit clock signal $\overline{CKR}$ is of substantially opposite phase to circuit clock signal CKR.

Parasitic capacitance CP1 associated with clock line 52 represents the equivalent sum of (a) the parasitic capacitances associated with the clock inputs of the function elements that receive circuit clock CKR in function circuitry 14 and (b) the parasitic capacitances of the clock-net lines that transmit clock CKR in circuitry 14. To a reasonable approximation, capacitance CP1 thereby represents the capacitive load presented by clock CKR to resonant system 50.

When resonant system 50 also generates circuit clock $\overline{CKR}$, parasitic capacitance CP2 associated with clock line 54 represents the equivalent sum of (a) the parasitic capacitances associated with the clock inputs of the function elements that receive circuit clock $\overline{CKR}$ in circuitry 14 and (b) the parasitic capacitances of clock-net lines that transmit clock $\overline{CKR}$ in circuitry 14. Capacitance CP2 then reasonably represents the capacitive load presented by clock $\overline{CKR}$ to system 50. The values $C_{P1}$ and $C_{P2}$ of capacitances CP1 and CP2 are usually very close to each other.

Resonant system 50 consists of a small driver 56, a resonating section 58, and a control circuit 60. Driver 56 amplifies input clock CKI to drive a driver clock signal CKD at input clock frequency $f_{CKI}$. Driver 56 may also drive a driver clock signal $\overline{CKD}$ substantially inverse in phase to driver clock CKD. Resonating section 58 produces circuit clock CKR and, when present, circuit clock $\overline{CKR}$. For purposes of pictorial illustration, Fig. 3 indicates that section 58 operates in response to driver clock CKD and, when present, driver clock $\overline{CKD}$.

Control circuit 60 controls the operation of resonant system 50 in response to input clock CKI and one or more feedback signals FB supplied from resonating section 58. For this purpose, control 60 may supply one or more resonator control signals RC to section 58. Depending on how components 58 and 60 are implemented, two or more of signals CKD, CKR, FB, and RC may be the same signal. Likewise, two or more of signals $\overline{CKD}$, $\overline{CKR}$, FB, and RC may be the same signal. Control 60 may furnish one or more additional control signals (not shown) to driver 56.

Resonant system 50 operates generally in the following manner. Circuit clock CKR switches between substantially fixed low and high voltage levels at circuit frequency $f_{CKR}$. Assume that clock CKR is at its high level so that parasitic capacitance CP1 is fully charged. When input clock CKI changes in such a way as to cause circuit clock CKR to be driven low, parasitic capacitance CP1 largely discharges along line 52 into resonating section 58. Instead of letting all the capacitive discharge energy be dissipated as heat, section 58 transfers part, usually considerably more than half, of the capacitive discharge energy to a temporary storage site. When clock CKR returns to its high level, section 58 recovers the capacitive energy stored at the temporary site and supplies that energy along line 52 to recharge capacitance CP1.

In a single-clock implementation of system 50, the temporary storage site is typically a capacitor. In a complementary-clock implementation, the temporary storage site is normally parasitic capacitance CP2. The charging and discharging of capacitance CP2 then occurs in a manner complementary to that of parasitic capacitance CP1.

In being driven by driver 56 at input clock frequency $f_{CKI}$ resonating section 58 oscillates in sympathy with input clock CKI so that circuit clock frequency $f_{CKR}$ substantially equals $f_{CKI}$ at steady-state. Section 58 and, consequently, resonant system 50 have a fundamental resonance frequency $f_R$ at which the system oscillations as represented by circuit clock CKR and, when present, circuit clock $\overline{CKR}$ locally reach maximum voltage amplitude as a function of input clock frequency $f_{CKI}$. System 50 is then in resonance.

Control circuit 60 adjusts the value of fundamental resonance frequency $f_R$ in order to make it very close to $f_{CKI}$. Resonant system 50 then goes substantially into resonance. The result is that (a) the voltage amplitudes of circuit clock CKR and, when present, circuit clock $\overline{CKR}$ reach local maxima, (b) the phase angle between circuit clock CKR and input clock CKI is approximately 0° or 180, and (c) the power consumed by driver 56 is minimized.

To ease the demands on control circuit 60, the values of the elements used to implement components 56 - 60 are chosen so that the nominal uncontrolled value $f_{RN}$ of resonance frequency $f_R$ is relatively close to input clock frequency $f_{CKI}$. Typically, $f_{RN}$ is slightly more than $f_{CKI}$. Although manufacturing variations may cause the actual uncontrolled value of frequency $f_R$ to differ significantly from $f_{RN}$, components 56 and 58 are implemented in a manner that still enables $f_R$ to be made close to $f_{CKR}$ and $f_{CKI}$. Accordingly, system 50 operates largely in resonance.

A small amount of energy is needed to initiate and sustain the resonant oscillations of resonating section 58. Driver 56 provides this energy. In addition, driver 56 provides energy to compensate for non-idealities such as the small clock-line resistance and the limited quality factors of the components in resonating section 58.

More particularly, resonance frequency $f_R$ depends (among other things) on the values of parasitic capacitance CP1 and, when present, parasitic capacitance CP2. Consider the case where circuit clock CKR is intended to be in phase with input clock CKI. If $f_R$ differs from $f_{CKI}$, a phase difference exists between clocks CKR and CKI (even though $f_{CKR}$ and $f_{CKI}$ are substantially the same). The sign and magnitude of this phase difference is monotonically related to the sign and magnitude of the frequency difference between $f_R$ and $f_{CKI}$.

Control circuit 60 normally senses the phase difference between clocks CKR and CKI. Control 60 may also sense how close the phase difference between clocks $\overline{CKR}$ and CKI is to 180°. Depending on the magnitude(s) and sign(s) of the phase difference(s), control 60 typically adjusts resonance frequency $f_R$ by appropriately adding/subtracting inductance and/or capacitance to bring $f_R$ close to $f_{CKR}$ and thus close to $f_{CKI}$.

Fig. 4 depicts a complementary-clock implementation of the synchronous circuit in Fig. 3. Resonating section 58 of Fig. 3 is implemented in Fig. 4 with a passive resonator 62 connected between clock lines 52 and 54. The lines carrying signals FB and RC, which can be the same signal, may connect to internal points of resonator 62 or to line 52 and/or line 54.

Function circuitry 14 in Fig. 4 consists of a group of function elements 14G having clock inputs connected through a clock net to lines 52 and 54. Each element 14G is illustrated as being responsive to both of circuit clocks CKR and $\overline{CKR}$. However, some of elements 14G could be responsive to only one of clocks CKR and $\overline{CKR}$.

When parasitic capacitance CP1 discharges as clock $\overline{CKR}$ goes from high to low during a half clock cycle, the CP1 charge largely flows along line 52, through resonator 62, and then along line 54 to charge parasitic capacitance CP2 as clock $\overline{CKR}$ simultaneously goes from low to high. The reverse occurs during the next half clock cycle in which clock CKR goes from low to high while clock $\overline{CKR}$ simultaneously goes from high to low. In this way, the capacitive charge alternately switches between capacitances CP1 and CP2 to keep power consumption low.

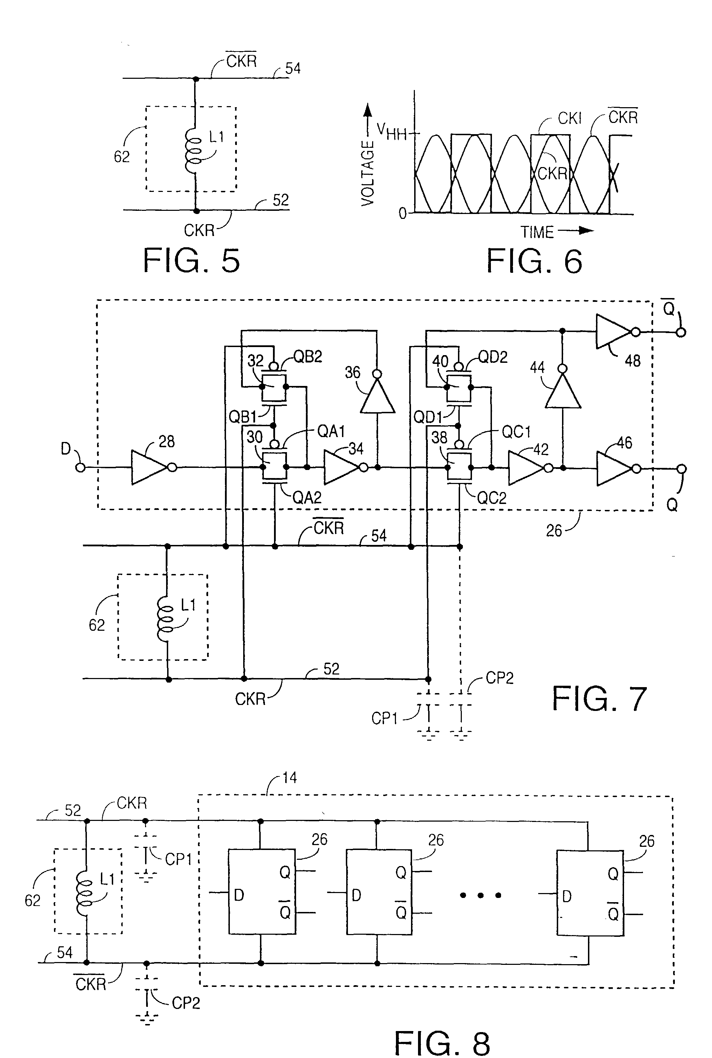

Resonator 62 in the complementary-clock implementation of Fig. 4 can be embodied simply with a main inductor L1 as shown in Fig. 5. In this case, resonance frequency $f_R$ approximately equals $1/2\pi\sqrt{L_1C_T}$ where $L_1$ is the value of inductor L1, and $C_T$ is the series equivalent capacitance of all parasitic and real capacitances in parallel with inductor L1. When resonator 62 consists solely of an inductor, the waveforms for clocks CKR and $\overline{CKR}$ are generally sinusoidal in shape. Fig. 6 illustrates a simplified example of the CKR and $\overline{CKR}$ waveforms when resonator 62 is an inductor, and the waveform for input clock CKI is substantially a square wave.

Fig. 7 depicts a partial embodiment of Fig. 4 for the case where resonator 62 is formed with inductor L1, and one of function elements 14G in circuitry 14 consists of flip-flop 26 described above in connection with Fig. 2. Instead of receiving driver clock signals CKD and $\overline{CKD}$ as in Fig. 2, the clock inputs of transmission gates 30, 32, 38, and 40 are connected to clock lines 52 and 54 to receive clocks CKR and $\overline{CKR}$ in Fig. 7. Aside from this difference, flip-flop 26 operates in the manner described above in connection with Fig. 2. Fig. 8 illustrates how the partial circuit of Fig. 7 is extended to include a group of flip-flops such as flip-flop 26.

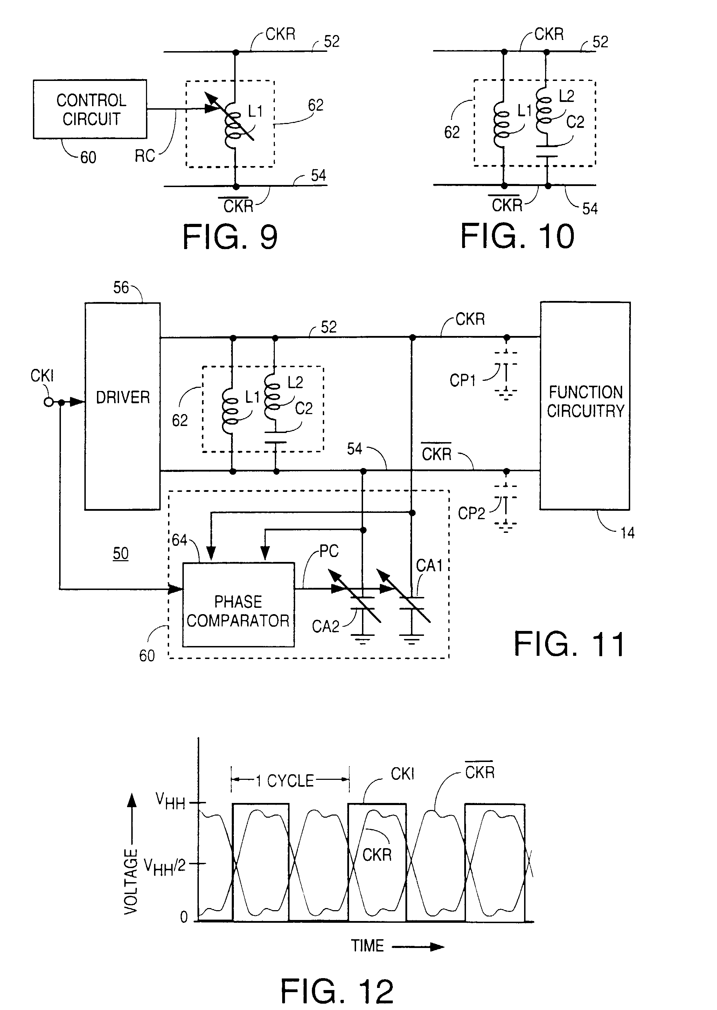

Inductor $L_1$ in resonator 62 can be a variable (or adjustable) inductor whose inductance is controlled to adjust resonance frequency $f_R$. Fig. 9 illustrates a partial embodiment of Fig. 4 where inductor $L_1$ is a variable inductor controlled by one signal RC from control circuit 60.

Manufacturing variations normally cause corresponding variations in the voltage switching thresholds of (otherwise identical) edge-triggered flip-flops and other level-sensitive switching devices. Since the time-domain waveforms for signals that cause the clock inputs of switching devices to change state invariably differ from the ideal square-wave shape, the difference in switching thresholds affects the synchronism of a circuit containing the switching devices. A square waveform for a signal that changes state at a given frequency consists of a weighted summation of the sinusoidal waveforms of the odd-numbered harmonics (or multiples) of the given frequency--i.e., the first harmonic (which is the given frequency), the third harmonic, the fifth harmonic, and so on.

The synchronism of the circuit in Fig. 4 is improved by adding a parallel combination of one or more inductive-capacitive ("LC") pairs to resonator 62. Each LC pair consists of an inductor and a capacitor connected in series with each other (and in parallel with inductor L1). Each LC pair enables an additional sinusoidal component to be included in the waveforms of clocks CKR and $\overline{CKR}$. The LC values of each LC pair are preferably chosen in such a way that the odd-numbered harmonics above the first harmonic of fundamental resonance frequency $f_R$ are incorporated into the CKR and $\overline{CKR}$ waveforms when $f_R$ equals $f_{CKI}$. The CKR and $\overline{CKR}$ waveforms thereby start to approximate square time-domain shapes.

The third harmonic is the most important harmonic (beyond the first) for creating a square waveform. Moving to Fig. 10, it illustrates an example in which an LC pair consisting of an inductor L2 and a capacitor C2 is incorporated into resonator 62 in parallel with inductor L1. The values of components L2 and C2 are chosen to produce the third harmonic of $f_R$ when it equals $f_{CKI}$.

Fig. 11 depicts an embodiment of Fig. 4 where resonator 62 is implemented as in Fig. 10, and control circuit 60 utilizes a phase comparison technique for adjusting resonance frequency $f_R$. Control 60 in Fig. 11 consists of a phase comparator 64 and a pair of variable capacitors CA1 and CA2. Phase comparator 64 compares the phases of circuit clocks CKR and $\overline{CKR}$ with the phase of input clock CKI. Depending on the phase differences, comparator 64 generates one or more signals PC that adjust the values of variable capacitors CA1 and CA2. Inasmuch as capacitors CA1 and CA2 are respectively in parallel with parasitic capacitances CP1 and CP2 and thus respectively increase the capacitances of clock lines 52 and 54, the nominal values of capacitances CP1 and CP2 are normally less than the values which would cause nominal value $f_{RN}$ to equal $f_{CKI}$.

Fig. 12 illustrates a simplified example for the CKR and $\overline{CKR}$ waveforms of Fig. 11 when the input CKI waveform is a square wave. The CKR and $\overline{CKR}$ waveforms in Fig. 12 include the third $f_R$ harmonic when $f_R$ equals $f_{CKI}$. As Fig. 12 shows, the CKR and $\overline{CKR}$ waveforms are now reasonable approximations of square waves.

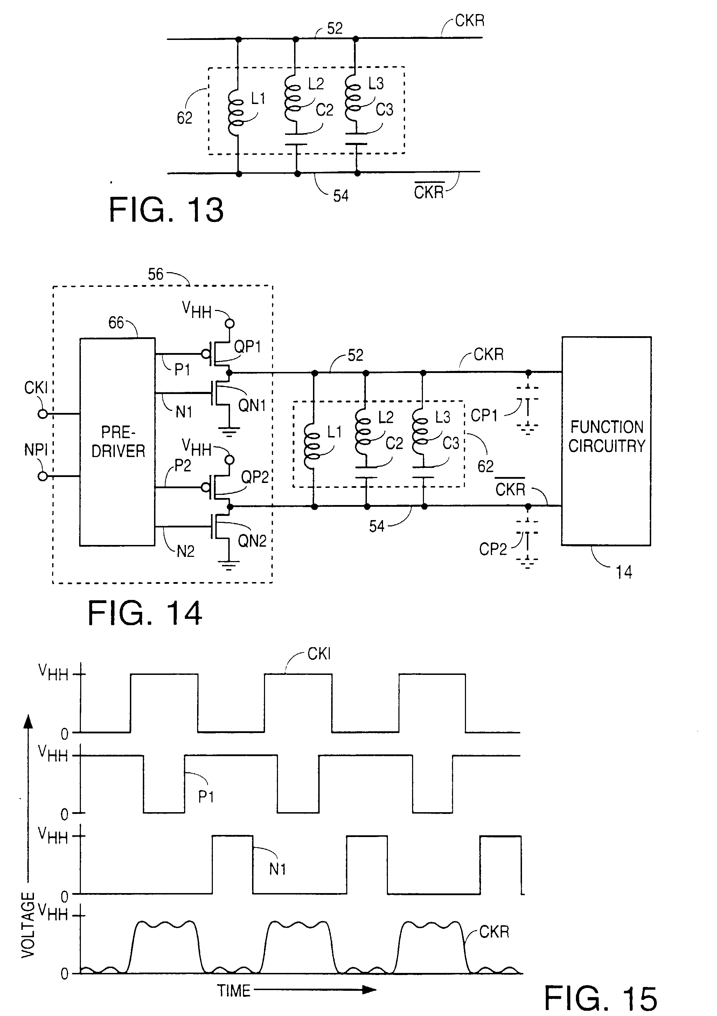

Fig. 13 illustrates an extension of resonator 62 in Fig. 10 in which a further LC combination consisting of an inductor L3 and a capacitor C3 is connected in parallel with inductor L1. The values of elements L3 and C3 are chosen so as to add the fifth $f_R$ harmonic to the CKR and $\overline{CKR}$ waveforms when $f_P$ equals $f_{CKI}$.

Fig. 14 depicts a partial embodiment of Fig. 4 where resonator 62 is implemented as in Fig. 13, and driver 56 consists of a pre-driver 66, a pair of serially connected complementary insulated-gate switching FETs QN1 and QP1, and a pair of serially interconnected complementary insulated-gate switching FETs QN2 and QP2. In response to input clock CKI and one or more additional input signals NPI, pre-driver 66 generates (a) a first pair of switching signals N1 and P1 that vary between ground reference and $V_{HH}$ at input frequency $f_{CKI}$ and (b) a second pair of switching signals N2 and P2 that likewise vary between ground reference and $V_{HH}$ at frequency $f_{CKI}$. FETs QN1 and QP1 furnish circuit clock CKR on line 52 in respective response to switching signals N1 and P1. FETs QN2 and QP2 similarly provide circuit clock $\overline{CKR}$ on line 54 in respective response to switching signals N2 and P2.

Fig. 15 illustrates simplified waveforms for switching signals N1 and P1. The waveforms for switching signals N2 and P2 (not shown) are respectively inverse in phase to the P1 and N1 waveforms. Each of signals N1, N2, P1, and P2 ideally has a square-wave shape. In each pair of signals Ni and Pi, where i equals 1 or 2, each signal Ni or Pi is at its active level only when the other signal Pi or Ni is at its inactive level. Hence, only one of signals Ni and Pi in each pair is active at a time. The pulse widths of signals N1, P1, N2, and P2 are determined by additional input signal(s) NPI.

By arranging for switching signals N1, P1, N2, and P2 to have the preceding characteristics, only one of FETs QNi and QPi in each FET pair is conductive at any time. At no time is a path from the $V_{HH}$ supply to ground created through (either) FET pair QNi and QPi. Also, because the (positive-going) Ni and (negative-going) Pi pulses are shorter than the CKI pulses, much of the energy dissipation that would otherwise occur in the QNi and QPi channel resistances due to the injection of current from the $V_{HH}$ supply when circuit clocks CKR and $\overline{CKR}$ are at values between $V_{HH}$ and ground reference is avoided. The power consumption is very low.

The harmonic content of the CKR and $\overline{CKR}$ waveforms can be controlled by adjusting the Ni and Pi waveforms. This also furnishes a mechanism for obtaining an optimum design trade-off between power consumption and slew rate when CKR and $\overline{CKR}$ change state. Increasing the Ni and Pi pulse widths increases the slew rate but consumes more power.

In addition to showing the N1 and P1 waveforms, Fig. 15 illustrates simplified waveforms for clocks CKI and CKR. Clock CKI is again depicted as a square wave. Because resonator 62 in Fig. 14 furnishes the third and fifth harmonics of frequency $f_R$ when it equals $f_{CKI}$, the CKR waveform is even closer to a square wave than in Fig. 12.

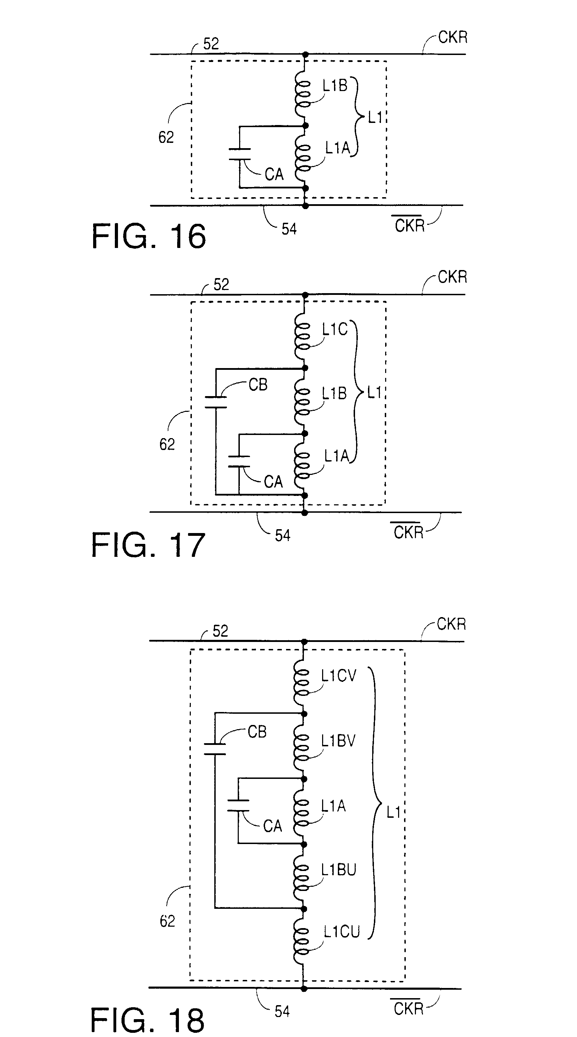

Referring to Fig. 16, a capacitor CA can be placed across part of inductor L1 in resonator 62. Inductor L1 then consists of portions L1A and L1B with capacitor CA connected in parallel with portion L1B. Elements L1A and L1B can be separate inductors. Resonator 62 in Fig. 16 operates in a similar manner to that of Fig. 10 to introduce the third $f_R$ harmonic frequency into the CKR and $\overline{CKR}$ waveforms.

In particular, the impedance of a capacitor decreases with increasing frequency. By appropriately choosing the value of capacitor CA, it appears largely as an open circuit at the first $f_R$ harmonic and as a short circuit at the third $f_R$ harmonic. The effective inductance $L_E$ of resonator 52 in Fig. 16 thus changes with frequency since part of the turns of inductor L1 are shorted out at high frequency. Resonance occurs at a frequency approximately equal to $1/2\pi\sqrt{L_E C_T}$. Consequently, a second resonance point arises at the third $f_R$ harmonic when $f_R$ equal $f_{CKI}$.

The principle of resonator 62 in Fig. 16 is readily extended to introduce odd-numbered $f_R$ harmonics above the third by utilizing two or more capacitors connected in parallel with various parts of inductor L1. Fig. 17 depicts an example in which inductor L1 is divided into three portions L1A, L1B, and L1C. Capacitor CA is again connected across portion L1A to add the third $f_R$ harmonic frequency by appropriately choosing the CA value so as to short out portion L1A at the third harmonic. In addition, a further capacitor CB is connected across portions L1A and L1B. By appropriate choice of the value of capacitor CB, it shorts out portions L1A and L1B at the fifth $f_R$ harmonic frequency to reduce $L_E$ and introduce the fifth harmonic into circuit clocks CKR and $\overline{CKR}$. Alternatively, elements L1A, L1B, and L1C can be separate inductors.

Resonator 62 of Fig. 17 can be equivalently implemented as shown in Fig. 18 where inductor L1 is divided into five portions L1A, L1BU, L1BV, L1CU, and L1CV. The sum of the L1BU and L1BV inductances equals the L1B inductance. Likewise, the sum of the L1CU and L1CV inductances equals the L1C inductance. Elements L1A, L1BU, L1BV, L1CU, and L1CV may all be separate inductors.

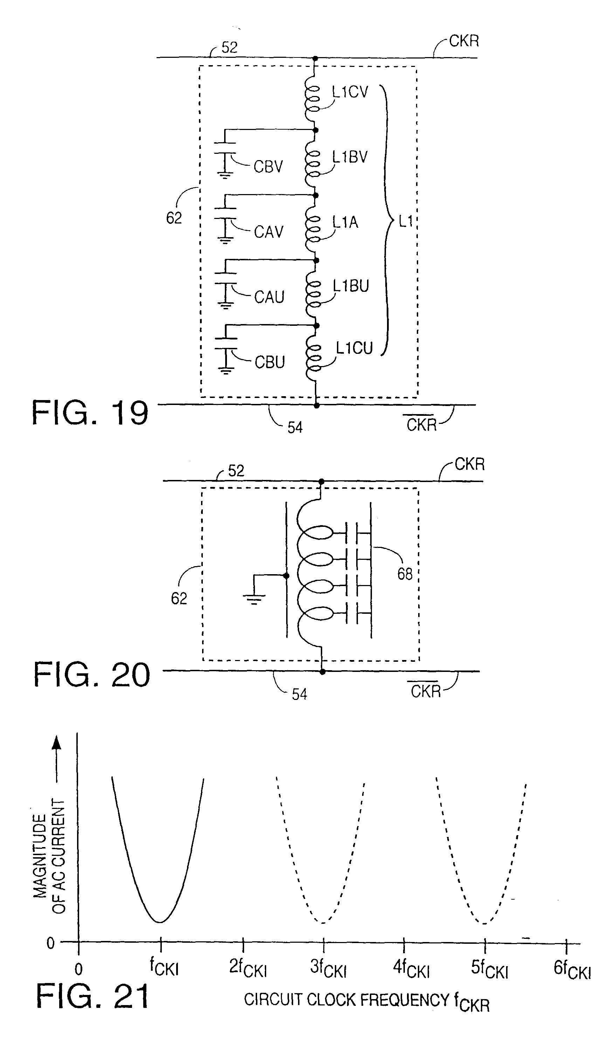

The resonance frequency characteristics of resonator 62 in Fig. 18 can alternatively be achieved by splitting each of capacitors CA and CB into two parts and grounding the lower capacitor plates. Fig. 19 shows how this alternative is achieved. Capacitor CA is replaced with a pair of equal-value capacitors CAU and CAV whose equivalent series capacitance equals the CA capacitance. Likewise, capacitor CB is replaced with a pair of equal-value capacitors CBU and CBV whose series equivalent capacitance equals the CB capacitance.

In the manner described in the last two paragraphs, resonator 62 of Fig. 16 can be equivalently implemented by simply deleting elements L1CU, L1CV, and CB in Fig. 18. The resonance frequency characteristics of the so-modified version of resonator 62 in Fig. 16 can then be alternatively achieved by simply deleting elements L1CU, L1CV, CBU, and CBV in Fig. 19. These principles readily extend to embodiments of resonator 62 having more inductor portions or inductors in series than shown in Figs. 16 - 19.

As a further alternative, the resonant frequency characteristics of resonators 62 in Figs. 16 - 19 can largely be achieved by using a distributed inductance-capacitance network commonly referred to as a transmission line. An example of this is depicted in Fig. 20 where the resonator 62 consists of a transmission line 68. Although inductance and capacitance are normally distributed equally along a transmission line, the inductance and capacitance can be distributed unequally along transmission line 68. Resonator 62 in Fig. 20 is an approximate analog to resonator 62 in Fig. 19.

In providing CKR and $\overline{CKR}$ waveforms with odd-numbered $f_R$ harmonics above the first harmonic, the magnitude of the AC impedance as seen from driver 56 reaches local maxima when $f_{CKR}$ is at odd multiples of $f_{CKI}$. The corresponding AC current reaches local minima as qualitatively illustrated in Fig. 21. Also, the phase angle of the AC impedance is approximately zero at the odd-numbered $f_R$ harmonics.

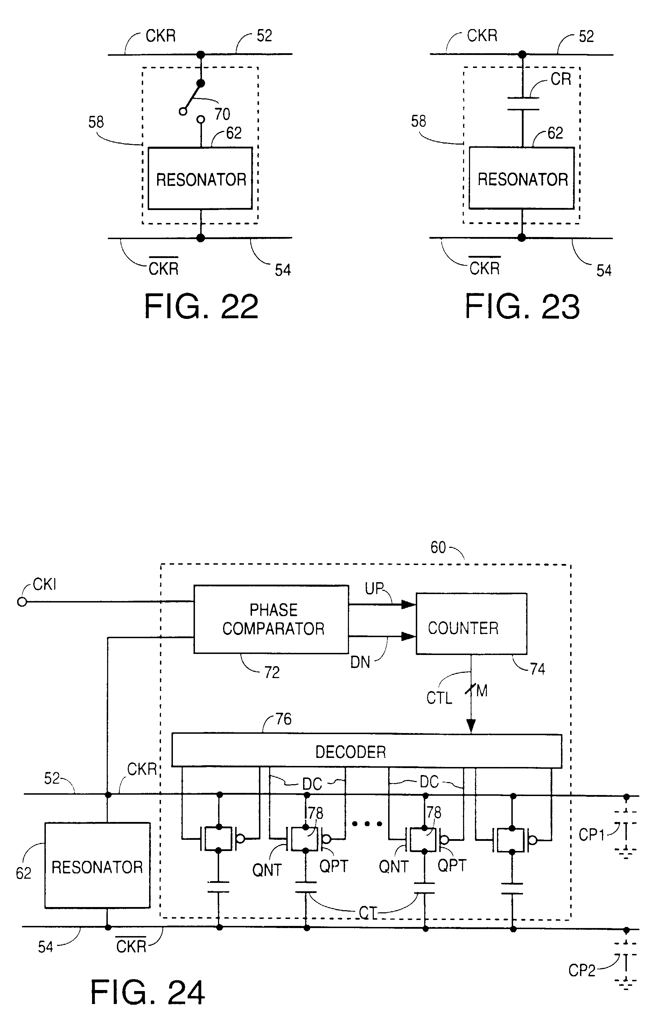

In complementary-clock embodiments where resonating section 58 is implemented with resonator 62, section 58 can be modified by placing one or two switches or one or two capacitors in series with resonator 62 between clock lines 52 and 54. Fig. 22 illustrates an example in which a switch 70 is inserted between line 52 and resonator 62. Fig. 23 depicts a similar example utilizing a capacitor CR. These two implementations of section 58 enable the clocking circuitry to go into an inactive mode without consuming shut-down power while certain other (typically asynchronous) parts of the circuit are active.

Fig. 24 illustrates a partial embodiment of Fig. 4 in which control circuit 60 consists of a phase comparator 72, an M-bit up/down counter 74, an M-to-$2^M$decoder 76, $2^M$ switches 78, and $2^M$ trimming capacitors CT. M is typically 8 or more. Each switch 78 consists of a pair of complementary insulated-gate FETs QNT and QPT arranged as a transmission gate. Control 60 in Fig. 24 can be used in any of the above-described embodiments of Fig. 4 for adjusting resonance frequency $f_R$ when the nominal value $C_{P1N}$ of parasitic capacitance CP1 is less than the parasitic capacitive value that would cause $f_R$ to equal $f_{CKI}$. This embodiment of control 60 interposes one or more of capacitors $C_T$ between lines 52 and 54 so as to effectively increase $C_{P1}$ and $C_{P2}$.

Phase comparator 72 senses the phase difference between input clock CKI and circuit clock CKR. Depending on the phase difference, comparator 72 either sends a signal UP to counter 74 to cause it to count up, or a signal DN to counter 74 to cause it to count down. In response, counter 74 furnishes decoder 76 with an M-bit signal CTR that indicates the number of capacitors CT to be interposed between lines 52 and 54. Decoder 76 then sends decode signals DC that cause appropriate ones of switches 78 to be closed (activated) to place the desired amount of capacitance between lines 52 and 54.

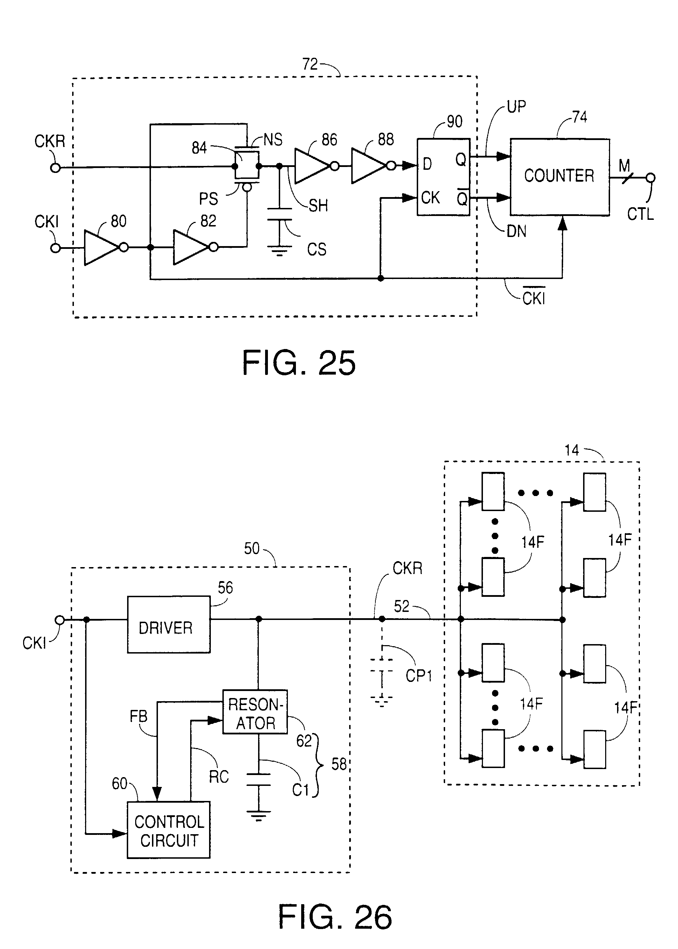

Fig. 25 illustrates an embodiment of phase comparator 72 in Fig. 24. In Fig. 25, comparator 72 is formed with CMOS inverters 80 and 82, a transmission gate 84, a charge-storage capacitor CS, CMOS inverters 86 and 88, and a D-type flip-flop 90. Transmission gate 84 consists of a pair of complementary insulated-gate FETs NS and PS connected in parallel.

Components 80 - 84 and CS form a sample-and-hold subcircuit which senses the phase difference between clocks CKR and CKI by sampling the voltage level of circuit clock CKR during its rising edge in response to the rising edge of input clock CKI to produce a corresponding sample-and-hold signal SH. Inverter 80 also inverts clock CKI to produce an inverted input clock signal $\overline{CKI}$. Capacitor CS stores the sampled CKR voltage during the high CKI phase. Inverters 86 and 88 form a buffer that amplifies signal SH to a logic "1" or logic "0" depending on the sign of the phase difference. When clock CKI goes low, the amplified SH signal is loaded into flip-flop 90 whose Q and $\overline{Q}$ outputs provide signals UP and DN to counter 74 in synchronism with input clock $\overline{CKI}$.

When resonance frequency $f_R$ is greater than input frequency $f_{CKI}$, the CKR waveform leads the CKI waveform. The phase difference is positive. Flip-flop 90 receives a "1" which causes counter 74 to count up. The reverse occurs when $f_R$ is less than $f_{CKI}$ so as to cause counter 74 to count down.

Fig. 26 illustrates a single-clock implementation of the synchronous circuit in Fig. 3. In this single-clock implementation, resonating section 58 of Fig. 3 consists of passive resonator 62 and a non-parasitic resonance capacitor C1 connected in series between circuit clock line 52 and circuit ground. Any of the embodiments of resonator 62 shown in Figs. 5, 9, 10, 13, and 16 - 20 can be used in the implementation of Fig. 26. Function circuitry 14 in Fig. 26 consists of function elements 14F that receive circuit clock CKR on line 52 by way of the clock net.

When circuit clock CKR goes from high to low during a half clock cycle so as to cause parasitic capacitance CP1 to discharge, the CP1 charge largely flows along line 52 and through resonator 62 to capacitor C1 which thereby charges up. During the next half clock cycle when CKR returns to its high value, the charge in capacitor C1 flows back through resonator 62 and along line 52 to recharge capacitance CP1. The charge on capacitance CP1 is thus reused to keep power consumption low.

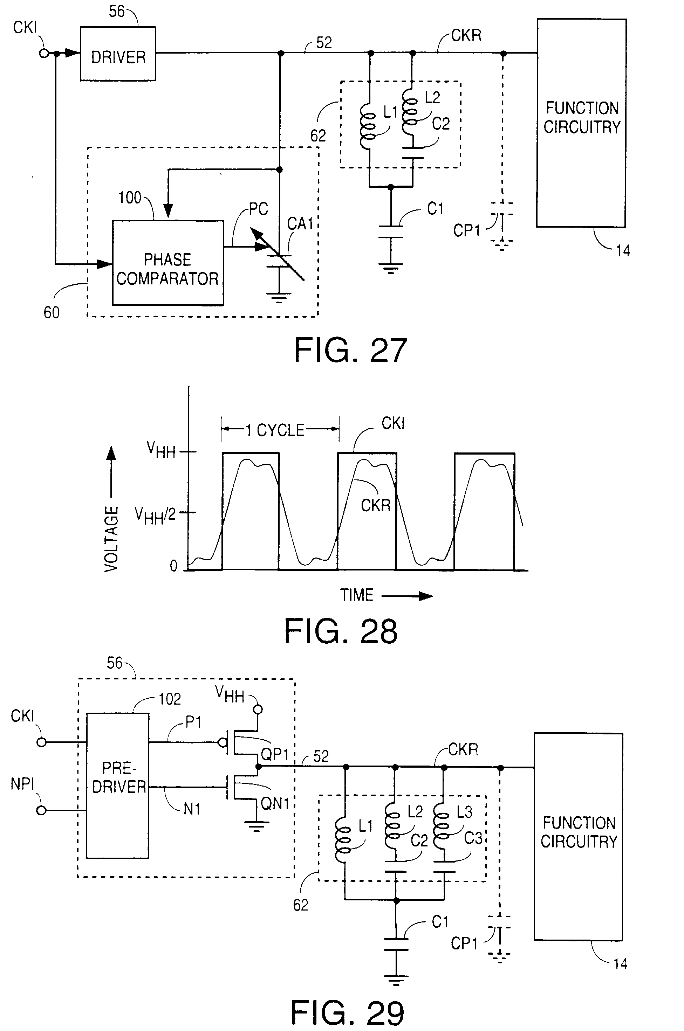

Fig. 27 depicts an embodiment of Fig. 26 in which resonator 62 is implemented as in Fig. 10, and control circuit 60 consists of a phase comparator 100 and variable capacitor CA1. Phase comparator 100 senses the phase difference between clocks CKR and CKI. Comparator 100 then adjusts resonance frequency $f_R$ by supplying control signal PC to capacitor CA1 to increase or decrease its capacitance. Control 60 in Fig. 27 is utilized when nominal parasitic capacitive value $C_{P1N}$ is less than the parasitic capacitive value that would cause $f_R$ to equal $f_{CKI}$.

Fig. 28 illustrates simplified clock waveforms for the circuit of Fig. 27. Elements L2 and C2 in resonator 62 of Fig. 27 are chosen so as to incorporate the third $f_R$ harmonic into the CKR waveform. As shown in Fig. 28, the CKR waveform thereby provides a reasonable approximation to a square wave.

Fig. 29 illustrates a partial embodiment of Fig. 26 where resonator 62 is implemented as in Fig. 13, and driver 56 consists of a pre-driver 102 and complementary FETs QN1 and QP1 as in driver 56 of Fig. 14. Pre-driver 102 in Fig. 29 furnishes switching signals N1 and P1 in response to input clock CKI and additional input signal(s) NPI. Signals N1 and P1 have the characteristics described above in connection with Figs. 14 and 15. FETs QN1 and QP1 likewise respond to signals N1 and P1 in the manner described above for Fig. 14. The circuit in Fig. 29 thus has the same type of power advantages as the circuit of Fig. 14. The simplified CKI and CKR clock waveforms of Fig. 15 also apply to the circuits of Fig. 29.

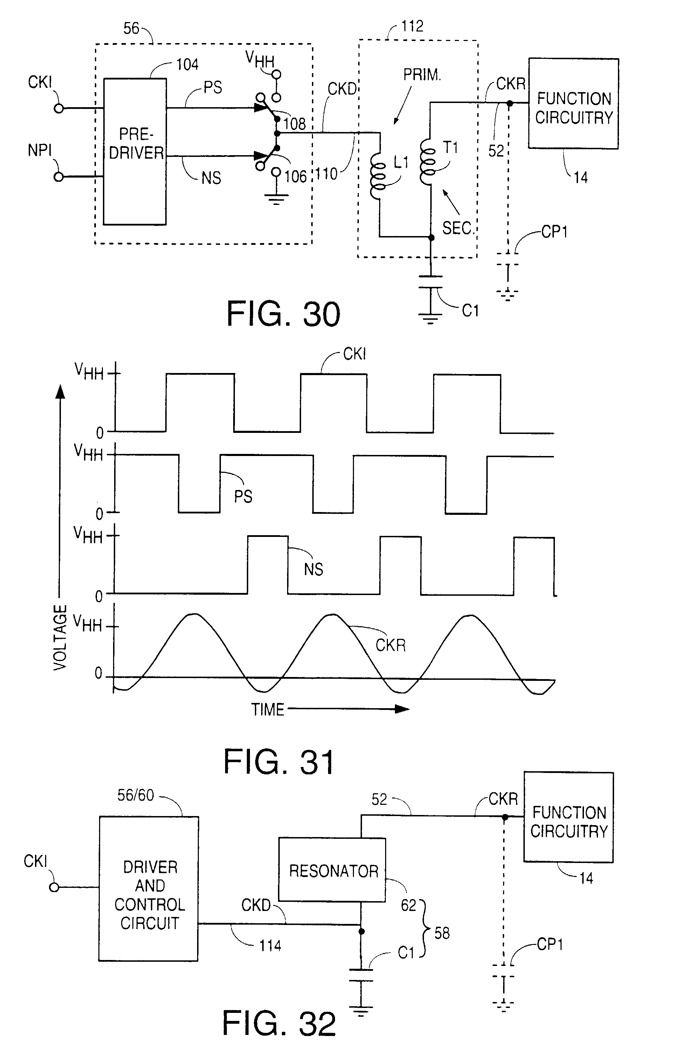

Turning to Fig. 30, it illustrates a partial single-clock implementation of the circuit of Fig. 3 where driver 56 consists of a pre-driver 104 and a pair of switches 106 and 108. In response to input clock CKI and input signal(s) NPI, pre-driver 104 generates switching signals NS and PS that typically have the characteristics described above for switching signals N1 and P1. Fig. 31 illustrates simplified waveforms for signals NS and PS. Switches 106 and 108 are connected in series between the $V_{HH}$ supply and ground. The interconnection point of switches 106 and 108 provides driver clock signal CKD on a driver clock line 110. Switches 106 and 108 operate in response to signals NS and PS in the same way that FETs QN1 and QP1 respond to signals N1 and P1 in the circuits of Figs. 16 and 26. Consequently, driver 56 in Fig. 30 generates driver clock signal CKD at low power consumption.

Resonating section 58 of Fig. 3 is implemented in Fig. 30 with a resonator 112 and resonance capacitor C1 whose lower plate is grounded. Resonator 112 consists of a transformer T1 whose primary coil is connected between line 110 and the upper C1 plate. The secondary coil of transformer T1 is connected between circuit clock line 52 and the upper C1 plate. Transformer T1 enables circuit clock CKR to have a greater voltage swing than input clock CKI. Fig. 31 also indicates simplified versions of the CKI and CKR waveforms. The secondary coil of transformer T1 may utilize, or be modified to utilize, any of the arrangements of Figs. 10, 13, and 16 - 20.

Fig. 32 depicts a single-clock implementation of Fig. 3 in which components 56 and 60 are merged into a composite driver/control circuit 56/60 that provides driver clock signal CKD on a driver clock line 114. In Fig. 32, resonating section 58 of Fig. 3 again consists of passive resonator 62 and capacitor C1. Resonator 62 in Fig. 32 can be implemented using any of the embodiments of Figs. 5, 9, 10, 13, and 16 - 20. Instead of circuit clock line 52 being connected to driver/control circuit 56/60, the interconnection node between resonator 62 and capacitor C1 is connected to circuit 56/60 by way of driver clock line 114.

The value C1 of capacitor C1 in the circuit of Fig. 32 is chosen to significantly exceed the nominal value $C_{P1N}$ of parasitic capacitance CP1. This enables capacitor C1 to hold a greater charge than capacitance CP1 at a given voltage. A voltage magnification approximately equal to $C_1/C_{P1N}$ thereby occurs when the C1 charge is transferred to capacitance CP1. Because driver clock CKD is supplied to the node between capacitor C1 and resonator 62, circuit clock CKR achieves a greater voltage swing than both driver clock CKD and input clock CKI.

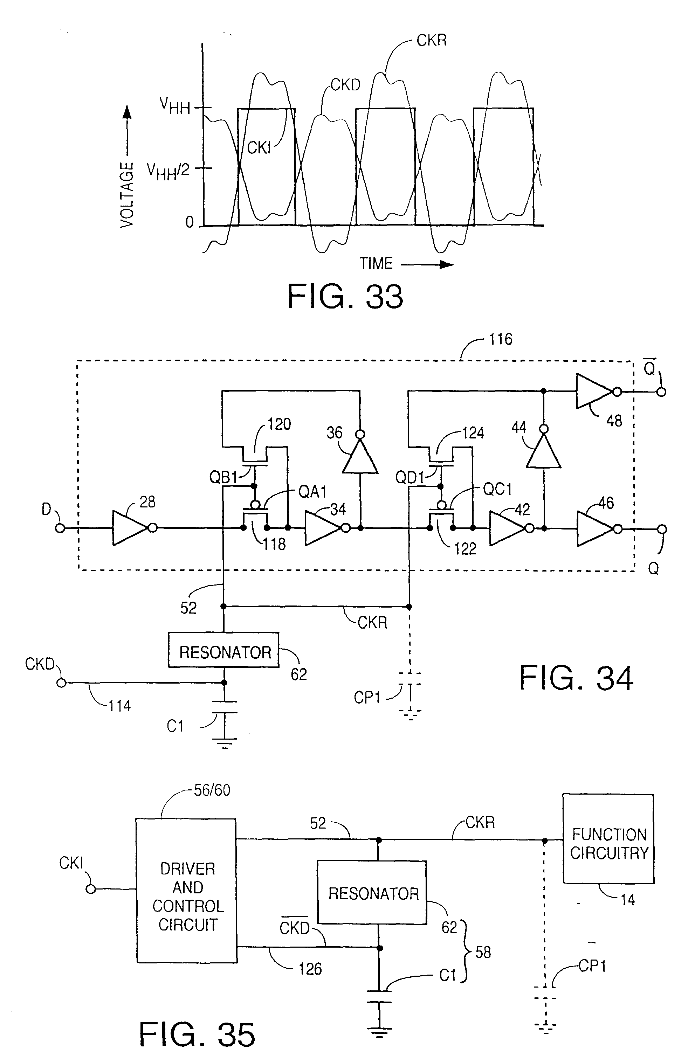

The CKR voltage swing in the circuit of Fig. 32 also exceeds the supply voltage for the circuit. For example, when $V_{HH}$ is 5 volts, circuit clock CKR can attain a voltage swing of 7 volts. The increased CKR voltage swing is obtained without adding a second power supply. Fig. 33 illustrates the increased CKR voltage swing for the case in which the CKR waveform include the third $f_R$ harmonic. Aside from the unbalanced capacitive values and the different connections for resonator 62, the circuit in Fig. 32 basically operates in the manner described above for Fig. 26.

Fig. 34 illustrates a partial embodiment of Fig. 32 in which function circuitry 14 contains a flip-flop 116 similar to flip-flop 26 in Figs. 2 and 7. Flip-flop 116 consists of a data input buffer, a master portion, a slave portion, and an output buffer. As in Figs. 2 and 7, the input buffer is formed with CMOS inverter 28 while the output buffer consists of CMOS inverters 46 and 48.

The master portion of flip-flop 116 is formed with transmission gates 118 and 120 and CMOS inverters 34 and 36. The slave portion is formed with transmission gates 122 and 124 and CMOS inverters 42 - 44. Instead of being CMOS gates like transmission gates 30, 32, 36, and 38 in Figs. 2 and 7, transmission gates 118 - 124 in Fig. 34 are single-FET gates respectively formed with FETs QA1 - QD1. Because the CKR voltage swing goes somewhat below ground and somewhat above $V_{HH}$, the second FET used in each of gates 30, 32, 36, and 38 of Figs. 2 and 7 is not necessary in the circuit of Fig. 34. The part count is thereby reduced.

Fig. 35 illustrates a hybrid single-clock implementation of the circuit in Fig. 3 where components 56 and 60 are again merged into driver/control circuit 56/60. In this case, circuit 56/60 furnishes circuit clock CKR and driver clock $\overline{CKD}$ respectively on circuit clock line 52 and a driver clock line 126. Clocks CKR and $\overline{CKD}$ are complementary to each other. Resonating section 58 of Fig. 3 again consists of resonator 62 and resonance capacitor C1 in Fig. 35. Driver clock line 126 is connected to the interconnection point between capacitor C1 and resonator 62.

The circuit in Fig. 35 basically operates in the manner described above for the circuit of Fig. 26. Because clocks CKR and $\overline{CKD}$ are complementary, the CKR waveform should be quite symmetrical.

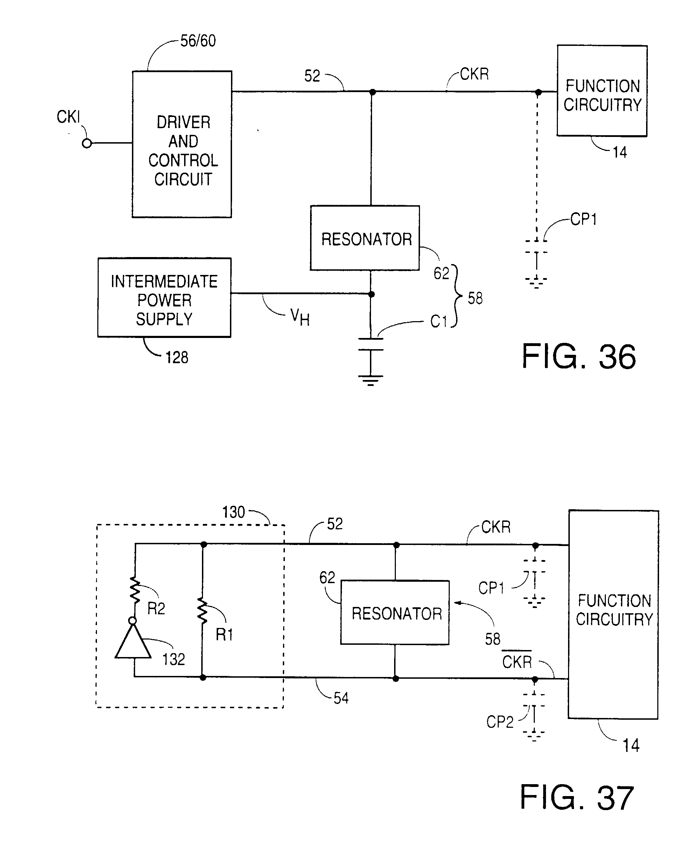

Fig. 36 depicts another single-clock implementation of the circuit in Fig. 3 where components 56 and 60 are merged into driver/control circuit 56/60. Resonator 62 in Fig. 36 is connected between circuit clock line 52 and a low-impedance source 128 that provides an intermediate power supply voltage $V_H$ approximately equal to the time-averaged voltage of circuit clock CKR. Typically, supply voltage $V_H$ is $V_{HH}/2$.

When parasitic capacitance CP1 discharges during a half clock cycle in the circuit of Fig. 36, the CP1 charge is largely transferred to $V_H$ supply 128. During the next half clock cycle, supply 128 charges capacitance CP1, thereby keeping power consumption very low. Capacitor C1 may optionally be connected between resonator 62 and ground to ensure that system efficiency is high.

In some of the previous embodiments of Fig. 3, driver 56 can be replaced with an oscillator that is not directly forced by an external stimulus such as input clock CKI. Instead, the forcing stimulus is derived from internal circuit clock CKR and/or internal circuit clock $\overline{CKR}$ so as to provide the phase shift needed to induce oscillation. Equivalently, driver 56 can be converted into such an internally driven oscillator by coupling clock CKR or $\overline{CKR}$ back to the CKI input of driver 56.

The internally driven oscillator tends to oscillate at resonance frequency $f_R$. Controlling frequency $f_R$ thereby controls circuit clock frequency $f_{CKR}$. The oscillator becomes a controllable oscillator employable, for example, in a phase-locked loop. One or more dividers or multipliers may be used to generate $f_{CKR}$ at some multiple or fraction of an external reference frequency.

Fig. 37 depicts a partial implementation of the circuit in Fig. 4 where driver 56 is replaced with an internally driven oscillator 130 connected between internal clock lines 52 and 54. Oscillator 130 contains an inverter circuit formed with a single CMOS inverter 132. Alternatively, the inverter circuit could be formed with an odd number of CMOS inverters connected front-to-back in series. Oscillator 130 also contains resistors R1 and R2 that provide bias and impedance matching.

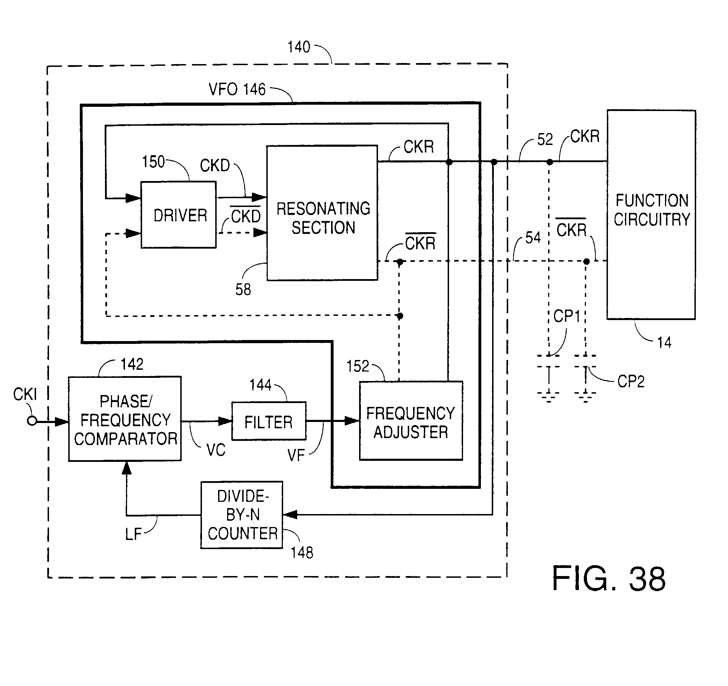

Fig. 38 illustrates a general configuration for a synchronous electronic circuit containing a resonant system 140 that supplies clock pulses to function circuitry 14 at low power consumption according to the invention. Resonant system 140 oscillates at circuit clock frequency $f_{CKR}$ in response to input (or reference) clock signal CKI at input clock frequency $f_{CKI}$. In system 140, $f_{CKR}$ is substantially an integer multiple of $f_{CKI}$, where the lowest integer multiplier is 1. Accordingly, $f_{CKR}$ is substantially proportional to $f_{CKI}$.

Resonant system 140 supplies circuit clock CKR to function circuitry 14 and, in complementary-clock implementations, supplies circuit clock $\overline{CKR}$ to circuitry 14. Parasitic capacitance CP1 associated with circuit clock line 52 and, when present, parasitic capacitance CP2 associated with circuit clock line 54 have the meanings described above in connection with the circuit of Fig. 3. Aside from the fact that $f_{CKR}$ is substantially proportional to $f_{CKI}$ but (unlike the circuit of Fig. 3) is not necessarily substantially equal to $f_{CKI}$, clocks CKI, CKR, and $\overline{CKR}$ have the characteristics described above in connection with the circuit of Fig. 3.

Resonant system 140 consists of a phase/frequency comparator 142, a low-pass filter 144, a variable-frequency oscillator ("VFO") 146, and an optional divide-by-N pulse counter 148 all arranged in a phase-locked loop. The input signals to phase/frequency comparator 142 are input clock CKI and a loop feedback signal LF at a feedback clock frequency $f_{LF}$. Comparator 142 senses the difference between frequencies $f_{CKI}$ and $f_{LF}$ and provides a comparator voltage signal VC indicative of the frequency difference. Filter 144 filters signal VC to produce a control voltage signal VF.

VFO 146 oscillates at circuit clock frequency $f_{CKR}$ as determined by control signal VF. VFO 146 also furnishes circuit clock CKR and, when present, circuit clock $\overline{CKR}$. In response to clock CKR, pulse counter 148 divides $f_{CKR}$ by an integer N to produce feedback signal LF at frequency $f_{LF}$. That is, $f_{LF}$ approximately equals $f_{CKR}/N$. If counter 148 is not present, the loop is completed by supplying clock CKR directly to the LF input of comparator 142. The phase-locked loop forces $f_{LF}$ to be substantially equal to $f_{CKI}$. Consequently, $f_{CKR}$ substantially equals $Nf_{CKI}$ where N is 1 in the absence of counter 148.

VFO 146 is formed with a small driver 150, resonating section 58, and frequency adjustor 152. Driver 150 generates driver clock signal CKD in response to circuit clock CKR and/or circuit clock $\overline{CKR}$. Driver 150 may also generate circuit clock signal $\overline{CKD}$. Responsive to driver clock CKD and, when present, driver clock $\overline{CKD}$, resonating section 58 produces circuit clocks CKR and $\overline{CKR}$ in the manner described above in connection with Fig. 3. Depending on the configurations of components 150 and 58, clocks CKR and CKD may be the same clock. Likewise, clocks $\overline{CKR}$ and $\overline{CKD}$ may be the same. Frequency adjustor 152 controls the value of $f_{CKR}$ in response to control voltage VF.

Resonant system 140 transfers charge between parasitic capacitance CP1 and a temporary storage site in the manner described above for resonant system 50 in Fig. 3. As with system 50, the temporary storage site is usually a capacitor in a single-clock implementation of system 140. In this case, resonating section 58 typically consists of resonator 62 in series with the capacitor. In a complementary-clock implementation, the temporary storage site is normally parasitic capacitance CP2. Section 58 then simply consists of resonator 62. System 140 oscillates very close to its fundamental resonance frequency $f_R$ in largely the same manner as system 50.

In essence, components 142, 144, and 148 - 152 in resonant system 140 form a controllable driver that, like the controllable driver formed by components 56 and 60 in resonant system 50, operates in response to input clock CKI for providing the small amount of energy needed to sustain the oscillations of resonating section 58 at circuit clock frequency $f_{CKR}$ very close to resonance frequency $f_R$. The two drivers differ in that $f_{CKR}$, and thus $f_R$, can exceed input clock frequency $f_{CKI}$ in system 140 but are substantially equal to $f_{CKI}$ in system 50.

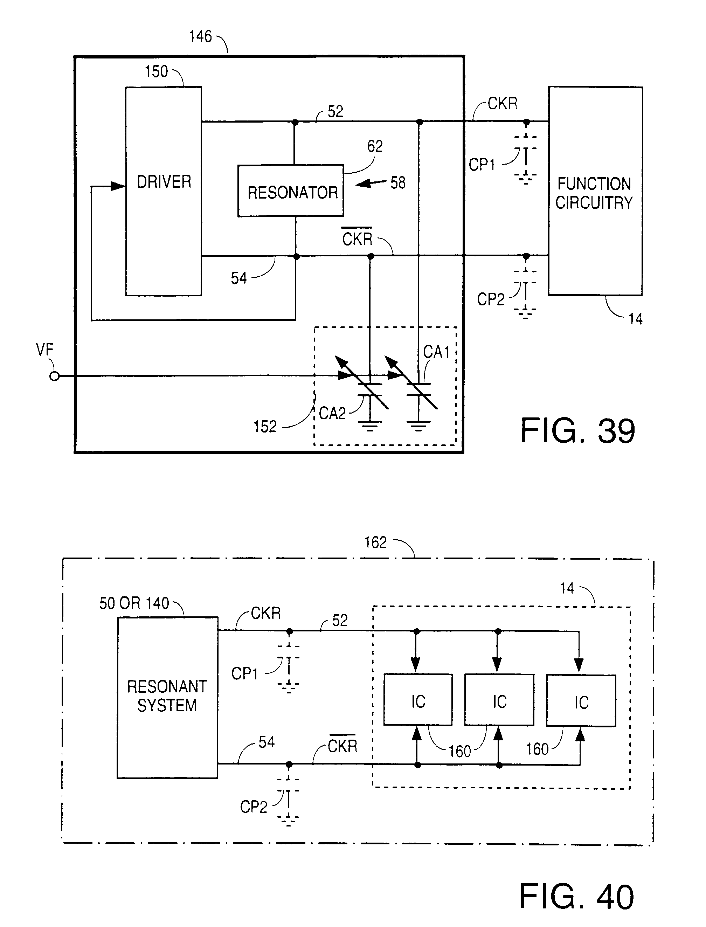

Fig. 39 shows part of a complementary-clock implementation of the synchronous circuit in Fig. 38. Resonating section 58 here consists of resonator 62 connected between lines 52 and 54. Resonator 62 in Fig. 39 can be implemented with any of the embodiments shown in Figs. 5, 9, 10, 13, and 16 - 20. Frequency adjustor 152 is formed with variable capacitors CA1 and CA2 whose values are controlled by voltage VF. Because capacitors CA1 and CA2 are respectively in parallel with parasitic capacitances CP1 and CP2, the nominal CP1 and CP2 values are usually less than the parasitic capacitive values which would cause the phase-locked loop to lock onto input clock CKI.

The synchronous circuit of Fig. 3 or 38 is often a single monolithic IC. Alternatively, function circuitry 14 can be divided among multiple monolithic ICs mounted on a common substrate. Resonant system 50 or 140 may be part of one of these ICs or contained in a separate monolithic IC. However, resonator 62 and, when present, capacitor C1 are often (a) provided as discrete components separately mounted on the substrate, (b) formed by metalization and dielectric layers on the substrate, or (c) provided on a separate substrate. Ceramic typically yields the best stability and performance as the substrate material. Fig. 40 illustrates part of a complementary-clock implementation of Fig. 3 or 38 in which the components of circuitry 14 are distributed among a group of monolithic ICs 160 mounted on a ceramic substrate 162.

While the invention has been described with reference to particular embodiments, this description is solely for the purpose of illustration and is not to be construed as limiting the scope of the invention claimed below. For example, the components of function circuitry 14 as well as resonant systems 50 and 140 could be implemented in bipolar or BiCMOS technology. PZT-type piezoelectric material may be suitable for manufacturing the elements of resonator 62.

Adjustable capacitors could be implemented with varicap diodes--i.e., reverse-biased semiconductor diodes whose capacitances depend on the applied reverse-bias voltages. Lower capacitor plates described as being connected to ground could generally be connected to a source of a voltage whose frequency is much lower than $f_{CKR}$, typically at least ten times lower.

Analogous to what is shown in Fig. 24 for complementary-clock implementations, a controllable capacitance network for single-clock implementations could be formed with a group of capacitor-gate pairs connected in parallel between circuit clock line 52 and ground, each capacitor-gate pair consisting of a transmission gate in series with a trimming capacitor. The transmission gate could be formed with a single insulated-gate FET or a pair of complementary insulated-gate FETs connected in parallel. Two such grounded networks could be used in complementary-clock implementations, one connected to each of clock lines 52 and 54.

A frequency multiplier or divider could be placed at the input to driver 56 in the circuit of Fig. 3. As a result, $f_{CKR}$ would substantially equal the resultant multiple or fraction of $f_{CKI}$.

As transistor switching speeds increase, parasitic inductances cause ringing problems to become progressively more severe. The resonance technique of the invention could be utilized to partially overcome the ringing by utilizing a resonance inductor whose inductance approximately equals the value needed for resonance minus the estimated value of the parasitic inductance. Various modifications and applications may thus be made by those skilled in the art without departing from the true scope of the invention as defined in the appended claims.

## Claims

1. An electronic circuit comprising:

   a resonant system (50 or 140) which, in response to an input clock signal (CKI) at an input clock frequency, oscillates at a circuit frequency substantially proportional to the input clock frequency to generate a first circuit clock signal (CKR) at the circuit frequency; and
   function circuitry (14) which performs electronic functions in synchronism with the circuit clock signal, clock inputs of the function circuitry receiving the circuit clock signal from a first circuit clock line (52), the resonant system being operated close to a fundamental resonance frequency such that a resonator (62) in the resonant system is largely in resonance at least with capacitance (CP1) and/or inductance associated with the circuit clock line and the clock inputs, characterised in that the oscillations of the resonant system include frequency components attributable to the fundamental resonance frequency and at least one resonance frequency of the resonant system other than the fundamental resonance frequency.

2. An electronic circuit as in claim 1 wherein the resonant system includes a non-parasitic capacitor (C1) coupled between the resonator and a source of a substantially fixed reference voltage or other voltage at a much lower frequency than the circuit frequency, the resonator being coupled to the circuit clock line.

3. An electronic circuit as in claim 1 wherein the resonator is coupled between the circuit clock line and a source (128) of a reference voltage ($V_H$) approximately equal to the time-averaged voltage of the circuit clock signal.

4. An electronic circuit as in claim 3 wherein the resonant system includes a non-parasitic capacitor (C1) coupled between (a) the source of the reference voltage and (b) a source of a substantially fixed further reference voltage or other voltage at a much lower frequency than the circuit frequency.

5. An electronic circuit as in Claim 1 wherein the resonant system generates a second circuit clock signal ($\overline{CKR}$) substantially inverse to the first circuit clock signal, at least part of the electronic functions of the function circuitry also being performed in synchronism with the second circuit clock signal.

**6.** An electronic circuit as in Claim 5 wherein the resonator is coupled between the first circuit clock line and a second circuit clock line (54) from which second clock inputs of the function circuitry receive the second circuit clock signal, the resonator also being largely in resonance with capacitance (CP2) and/or inductance associated with the second circuit clock line and the second clock inputs.

**7.** An electronic circuit as in Claim 6 wherein the resonant system includes at least one switch (70) or capacitor (CR) coupled between the circuit clock lines in series with the resonator.

**8.** An electronic circuit as in any preceding claim wherein the resonator comprises a non-parasitic main inductive device comprising an inductor (L1) or a group of inductors (L1A and L1B) coupled to one another in series.

**9.** An electronic circuit as in Claim 8 wherein the main inductive device has a controllably variable inductance.

**10.** An electronic circuit as in Claim 8 or 9 wherein the resonator includes at least one inductive-capacitive arrangement coupled in parallel with at least part of the main inductive device, each inductive-capacitive arrangement comprising an inductor (L2) and a capacitor (C2) coupled to each other in series.

**11.** An electronic circuit as in Claim 8, 9, or 10 wherein the resonator includes at least one capacitor (CA) coupled in parallel with part of the main inductive device.

**12.** An electronic circuit as in Claim 8, 9, 10 or 11 wherein the resonator includes at least one capacitor (CAU) coupled between an internal point of the main inductive device and a source of a substantially fixed reference voltage or other voltage at a much lower frequency than the circuit frequency.

**13.** An electronic circuit as in Claim 8, 9, 10, 11 or 12 wherein the resonator includes a distributed capacitor (68) coupled to multiple points of the main inductive device.

**14.** An electronic circuit as in any preceding claim wherein the resonant system includes control circuitry (60) that adjusts the fundamental resonance frequency.

**15.** An electronic circuit as in Claim 14 wherein the control circuitry adjusts the fundamental resonance frequency by changing inductance and/or capacitance values.

**16.** An electronic circuit as in Claim 14 or 15 wherein the control circuitry includes at least one variable capacitor (CA1) whose capacitance is adjustable in response to at least one control signal.

**17.** An electronic circuit as in Claim 14, 15, or 16 wherein the control circuitry is arranged in a phase-locked loop.

**18.** An electronic circuit as in Claim 14 or 15 wherein the control circuitry includes a plurality of capacitive-gate arrangements coupled to one another in parallel for controllably changing capacitance values in response to at least one control signal, each capacitive-gate arrangement comprising a capacitor (CT) and a transmission gate (78) coupled to each other in series.

**19.** An electronic circuit as in Claim 14, 15, 16, 17 or 18 wherein the control circuitry includes a phase comparator (72 or 100) that compares the phases of the input clock signal and the first circuit clock signal.

**20.** An electronic circuit as in any preceding claim wherein the oscillations of the resonant system locally reach maximum amplitude when they occur at any of the resonance frequencies of the resonant system, including the fundamental resonance frequency.

**21.** An electronic circuit as in any preceding claim wherein the circuit frequency is substantially an integer multiple of the input frequency, whereby the fundamental resonance frequency approximately equals the same integer multiple of the input frequency, the integer multiple including one as the lowest integer multiplier.

**22.** An electronic circuit as in Claim 21 wherein the resonant system controllably adjusts the fundamental resonance frequency towards the integer multiple of the input frequency.

**23.** An electronic circuit as in any preceding claim wherein the resonant system includes a driver (56) via which each circuit clock signal is supplied in response to the input clock signal.

**24.** An electronic circuit as in Claim 2 wherein the resonant system includes a driver (56/60) responsive to the input clock signal for providing a driver signal ($\overline{CKD}$) to a node between the resonator and the capacitor.

**25.** An electronic circuit as in Claim 23 or 24 wherein the driver comprises:

a pre-driver (102 or 104) that generates a pair of switching signals substantially in synchronism with the input clock signal, each switching signal having an active level and an inactive level, each switching signal being at its inactive level only when the other switching signal is at its active level, whereby only one of the switching signals is active at any time; and
a pair of switches (QN1 and QP1 or 106 and 108) coupled together to a driver line (52 or 110) and coupled in series between a pair of different voltage supplies, the switches being respectively responsive to the switching signals for enabling current to flow through the driver line when either switching signal is at its active level.

**26.** An electronic circuit as in Claim 25 wherein the switches comprise a pair of complementary field-effect transistors (QN1 and QP1) having respective drains coupled together to the driver line, respective sources respectively coupled to the voltage supplies, and respective gate electrodes that respectively receive the switching signals.

**27.** An electronic circuit as in any preceding claim wherein oscillations of the resonant system include harmonics of approximately the fundamental resonance frequency.

**28.** An electronic circuit as in Claim 27 wherein the harmonics are odd-numbered harmonics.

**29.** An electronic circuit as in any preceding claim wherein each circuit clock signal has a substantially different voltage swing than the input clock signal.

**30.** An electronic circuit as in any preceding claim wherein each circuit clock signal has a substantially greater voltage swing than the input clock signal.

**31.** An electronic circuit as in Claim 30 wherein the function circuitry includes at least one circuit element comprising:

complementary first and second field-effect transistors ("FETs") (118,120), each having a first source/drain electrode, a second source/drain electrode, and a gate electrode coupled to the resonator (62), a data input signal (D) being supplied to the first source/drain electrode of the first FET (118);
a first inverter (34) having (a) an input coupled to the second source/drain electrodes of the first and second FETs and (b) an output for providing a data output signal; and
a second inverter (36) having (a) an input coupled to the output of the first inverter and (b) an output coupled to the first source/drain electrode of the second FET (120).

**32.** An electronic circuit as in any preceding claim wherein the electronic circuit is part of a single integrated circuit.

**33.** An electronic circuit as in any preceding claim wherein the electronic circuit is distributed across at least two integrated circuits (160) mounted on a common substrate (162).

**34.** An electronic circuit as in any preceding claim wherein the function circuitry comprises CMOS, bipolar, or BiCMOS components.

**35.** An electronic circuit as in any preceding claim wherein the function circuitry includes level-sensitive state elements (14G;26 or 116).

**36.** An electronic circuit comprising:

function circuitry (14) which performs electronic functions, specified elements (14G;26 or 116) of the function circuitry changing state in synchronism with a first circuit clock signal (CKR) provided from a first circuit clock line (52) to clock inputs of the specified elements at a circuit frequency; and
a resonant system (50 or 140) which oscillates at the circuit frequency, the resonant system being operated close to a fundamental resonance frequency such that a resonator (62) in the resonant system is largely in resonance with capacitance (CP1) and/or inductance associated with the circuit clock line and the clock inputs, the resonant system being coupled to the function circuitry to assist the specified elements in changing state by helping to overcome capacitances and/or inductances associated with the function circuitry, oscillations of the resonant system including frequency components attributable to the fundamental resonance frequency and at least one resonance frequency of the resonant system other than the fundamental resonance frequency.

**37.** An electronic circuit as in claim 36 wherein the oscillations of the resonant system include harmonics of approximately the fundamental resonance frequency.

**38.** An electronic circuit as in claim 37 wherein the harmonics are odd-numbered harmonics.

**39.** An electronic circuit as in any of Claims 37 to 40 wherein the resonator comprises a self-driven oscillator (130).

**40.** An electronic circuit as in any preceding claim wherein each circuit clock line is passively connected between the resonator and the function circuitry.

**41.** An electronic circuit as in any preceding claim wherein the resonator comprises:

a main section (L1) that provides oscillations of the resonant system with a frequency component substantially at the fundamental resonance frequency; and
a further section (L2 and C2) that provides oscillations of the resonant system with a frequency component substantially at a harmonic resonance frequency above the fundamental resonance frequency.

**42.** An electronic circuit as in Claim 41 wherein the harmonic resonance frequency is an odd-numbered harmonic.

**43.** An electronic circuit as in any preceding claim wherein energy is transferred in a resonant manner among the resonator, a temporary storage site (C1 or CP2), and capacitance (CP1) and/or inductance associated with the first circuit clock line and the clock inputs that receive the first circuit clock signal.

**44.** An electronic circuit as in any of Claims 1-43 for use in a digital electronic circuit wherein repetitive pulses for control or synchronization are supplied by resonant charge storage means in preference to resistive switching means.

**45.** An electronic circuit as in any of Claims 1-43 for use in a clock drive circuit having resonant output means adapted to resonate in accordance with a desired clock frequency.

**46.** An electronic circuit as in any preceding claim wherein said other resonant frequency component (s) is or are weighted in amplitude relative to the fundamental resonancy frequency component so that the clock signal approximates a square wave.

**Patentansprüche**

**1.** Elektronische Schaltung, die umfaßt

ein Resonanzsystem (50 oder 140), das - als Antwort auf ein Eingangstaktsignal (CKI) bei einer Eingangstaktfrequenz - bei einer Schaltungsfrequenz schwingt, die im wesentlichen proportional der Eingangstaktfrequenz ist, um bei der Schaltungsfrequenz ein erstes Schaltungstaktsignal (CKR) zu erzeugen; und

einen Funktionsschaltkreis (14), der synchron mit dem Schaltungstaktsignal elektronische Funktionen durchführt, wobei die Takteingänge des Funktionsschaltkreises das Schaltungstaktsignal von einer ersten Schaltungstaktleitung (52) aufnehmen, und das Resonanz system in der Nähe einer Grundresonanzfrequenz derart betrieben wird, daß ein Resonator (62) in dem Resonanzsystem mindestens mit einer Kapazität (CP1) und/oder einer Induktivität, die mit der Schaltungstaktleitung und den Takteingängen verbunden sind, überwiegend in Resonanz ist, dadurch gekennzeichnet, daß die Schwingungen des Resonanzsystems Frequenzkomponenten einschließen, die der Grundresonanzfrequenz und mindestens einer Resonanzfrequenz des Resonanzsystems, die anders als die Grundresonanzfrequenz ist, zuzuschreiben sind.

**2.** Elektronische Schaltung nach Anspruch 1, bei der das Resonanzsystem einen nichtparasitären Kondensator (C1) einschließt, der zwischen den Resonator und eine Quelle mit im wesentlichen feststehender Bezugsspannung oder anderer Spannung bei einer viel geringeren Frequenz als die Schaltungsfrequenz geschaltet ist, wobei der Resonator an die Schaltungstaktleitung gekoppelt ist.

**3.** Elektronische Schaltung nach Anspruch 1, bei der der Resonator zwischen die Schaltungstaktleitung und eine Quelle (128) einer Bezugsspannung ($V_H$) geschaltet ist, die ungefähr gleich der zeitlichen Durchschnittsspannung des Schaltungstaktsignals ist.

**4.** Elektronische Schaltung nach Anspruch 3, bei der das Resonanzsystem einen nichtparasitären Kondensator (C1) einschließt, der zwischen (a) die Quelle der Bezugsspannung und (b) eine Quelle einer im wesentlichen feststehenden weiteren Bezugsspannung oder anderen Spannung bei einer viel geringeren Frequenz als der Schaltungsfrequenz geschaltet ist.

**5.** Elektronische Schaltung nach Anspruch 1, bei der das Resonanzsystem ein zweites Schaltungstaktsignal ($\overline{CKR}$) erzeugt, das zum ersten Schaltungstaktsignal im wesentlichen entgegengesetzt ist, wobei mindestens ein Teil der elektronischen Funktionen des Funktionsschaltkreises auch synchron mit dem zweiten Schaltungstaktsignal durchgeführt wird.

**6.** Elektronische Schaltung nach Anspruch 5, bei der der Resonator zwischen die erste Schaltungstaktleitung und eine zweite Schaltungstaktleitung (54), von der die zweiten Schaltungseingänge des Funktionsschaltkreises das zweite Schaltungstaktsignal empfangen, geschaltet ist, wobei der Resonator auch zum größten Teil in Resonanz mit einer Kapazität (CP2) und/oder einer Induktivität ist, die mit der zweiten Schaltungstaktleitung und den zweiten Takteingängen verbunden sind.

**7.** Elektronische Schaltung nach Anspruch 6, bei der das Resonanzsystem mindestens einen Schalter (70) oder Kondensator (CR) einschließt, die in Reihe mit dem Resonator zwischen die Schaltungstaktleitungen geschaltet sind.

**8.** Elektronische Schaltung nach einem der vorhergehenden Ansprüche, bei der der Resonator eine nichtparasitäre Hauptinduktionsvorrichtung umfaßt, die einen Induktor (L1) oder eine Gruppe miteinander in Reihe geschalteter Induktoren (L1A und L1B) umfaßt.

**9.** Elektronische Schaltung nach Anspruch 8, bei der die Induktionsvorrichtung eine regelbare veränderliche Induktivität (Induktionsvariator) aufweist.

**10.** Elektronische Schaltung nach Anspruch 8 oder 9, bei der der Resonator mindestens eine induktiv-kapazitive Anordnung einschließt, die parallel an mindestens einen Teil der Hauptinduktionsvorrichtung geschaltet ist, wobei jede induktiv-kapazitive Anordnung einen Induktor (L2) und einen Kondensator (C2), die miteinander in Reihe geschaltet sind, umfaßt.

**11.** Elektronische Schaltung nach Anspruch 8, 9 oder 10, bei der der Resonator mindestens einen Kondensator (CA) einschließt, der mit einem Teil der Hauptinduktionsvorrichtung parallelgeschaltet ist.

**12.** Elektronische Schaltung nach Anspruch 8, 9, 10 oder 11, bei der der Resonator mindestens einen Kondensator (CAU) einschließt, der zwischen einen inneren Punkt der Hauptinduktionsvorrichtung und eine Quelle einer im wesentlichen feststehenden Bezugsspannung oder anderen Spannung bei einer viel geringeren Frequenz als der Schaltungsfrequenz geschaltet ist.

**13.** Elektronische Schaltung nach einem der Ansprüche 8, 9, 10, 11 oder 12, bei der der Resonator einen verteilten Kondensator (68) einschließt, der an vielfache Punkte der Hauptinduktionsvorrichtung angeschlossen ist.

**14.** Elektronische Schaltung nach einem der vorhergehenden Ansprüche, bei der das Resonanzsystem einen Steuerkreis (60) einschließt, der die Grundresonanzfrequenz einstellt.

**15.** Elektronische Schaltung nach Anspruch 14, bei der der Steuerkreis die Grundresonanzfrequenz durch Änderung der Induktivitäts- und/oder Kapazitätswerte einstellt.

**16.** Elektronische Schaltung nach Anspruch 14 oder 15, bei der der Steuerkreis mindestens einen veränderlichen Kondensator (CA1) einschließt, dessen Kapazität als Antwort auf mndestens ein Steuersignal einstellbar ist.

**17.** Elektronische Schaltung nach einem der Ansprüche 14, 15 oder 16, bei der der Steuerkreis in einem Phasenregelkreis (PLL-Kreis) angeordnet ist.

**18.** Elektronische Schaltung nach Anspruch 14 oder 15, bei der der Steuerkreis eine Mehrzahl zueinander parallel geschalteter Kapazitiv-Gate-Anordnungen zur regelbaren Änderung der Kapazitätswerte als Antwort auf mindestens ein Steuersignal einschließt, wobei jede Kapazitiv-Gate-Anordnung einen Kondensator (CT) und ein Übertragungsgate (78) umfaßt, die miteinander in Reihe geschaltet sind.

**19.** Elektronische Schaltung nach Anspruch 14, 15, 16, 17 oder 18, bei der der Steuerkreis einen Phasenvergleicher (72 oder 100) einschließt, der die Phasen des Eingangstaktsignals und des ersten Schaltungstaktsignals vergleicht.

**20.** Elektronische Schaltung nach einem der vorhergehenden Ansprüche, bei der die Schwingungen des Resonanzsystems örtlich eine Maximalamplitude erreichen, wenn sie bei irgendeiner der Resonanzfrequenzen des Resonanzsystems, einschließlich der Grundresonanzfrequenz, auftreten.

**21.** Elektronische Schaltung nach einem der vorhergehenden Ansprüche, bei der die Schaltungsfrequenz ein ganzzahliges Vielfaches der Eingangsfrequenz ist, wodurch die Grundresonanzfrequenz annähernd dem gleichen ganzzahligen Vielfachen der Eingangs frequenz gleichkommt, wobei das ganzzahlige Vielfache das niedrigste ganzzahlige Vielfache einschließt.

**22.** Elektronische Schaltung nach Anspruch 21, bei der das Resonanzsystem die Grundresonanzfrequenz regelbar auf das ganzzahlige Vielfache der Eingangs frequenz einstellt.

**23.** Elektronische Schaltung nach einem der vorhergehenden Ansprüche, bei der das Resonanzsystem einen Treiber (56) einschließt, über den das jeweilige Schaltungstaktsignal als Antwort auf das Eingangstaktsignal zugeführt wird.

**24.** Elektronische Schaltung nach Anspruch 2, bei der das Resonanzsystem einen Treiber (56/60) einschließt, der zur Lieferung eines Treibersignals (CKD) an einen Knotenpunkt zwischen dem Resonator und dem Kondensator auf das Eingangstaktsignal reagiert.

**25.** Elektrische Schaltung nach Anspruch 23 oder 24, in der der Treiber umfaßt:

einen Vortreiber (102 oder 104), der ein Paar Schaltsignale erzeugt, die im wesentlichen synchron mit dem Eingangstaktsignal sind, wobei jedes Schaltsignal einen aktiven Pegel und einen inaktiven Pegel aufweist und das jeweilige Schaltsignal nur auf seinem inaktiven Pegel ist, wenn das andere Schaltsignal auf seinem aktiven Pegel ist, wodurch nur eines der Schaltsignale zu einer beliebigen Zeit aktiv ist; und

ein Paar Schalter (QN1 und QP1 oder 106 und 107), die zu einer Schalterleitung aneinandergekoppelt sind und zwischen ein Paar unterschiedliche Spannungszuführungen in Reihe geschaltet sind, wobei die Schalter jeweils auf die Schaltsignale ansprechen, um zu ermöglichen, daß Strom durch die Treiberleitung fließt, wenn sich jedes Schaltsignal auf seinem aktiven Pegel befindet.

**26.** Elektronische Schaltung nach Anspruch 25, bei der die Schalter ein Paar komplementärer Feldeffekttransistoren (QN1 und QP1) umfaßt, die jeweils zusammen an die Treiberleitung gekoppelte Drains, jeweils Quellen, die jeweils an die Spannungszuführungen angeschlossen sind, und jeweils Gattelektroden, die jeweils die Schaltsignale empfangen, aufweisen.

**27.** Elektronische Schaltung nach einem der vorhergehenden Ansprüche, bei der die Schwingungen des Resonanzsystems Oberschwingungen mit annähernd der Grundresonanzfrequenz einschließen.

**28.** Elektronische Schaltung nach Anspruch 27, bei der die Oberschwingungen ungeradzahlige Oberschwingungen sind.

**29.** Elektronische Schaltung nach einem der vorhergehenden Ansprüche, bei der das jeweilige Schaltungstaktsignal eine im wesentlichen unterschiedliche Spannungsschwingung gegenüber dem Eingangstaktsignal hat.

**30.** Elektronische Schaltung nach einem der vorhergehenden Ansprüche, bei der das jeweilige Schaltungstaktsignal eine im wesentlichen größere Spannungsschwingung als das Eingangstaktsignal aufweist.

**31.** Elektronische Schaltung nach Anspruch 30, bei der der Funktionsschaltkreis mindestens ein Schaltungselement einschließt, das umfaßt:

komplementäre erste und zweite Feldeffekttransitoren ("FETs") (118, 120), die jeweils eine erste Quellen/Drain-Elektrode, eine zweite Quellen/Drain-Elektrode und eine an den Resonator (62) angeschlossene Gattelektrode aufweisen, wobei ein Dateneingangssignal (D) der ersten Quellen/Drain-Elektrode des ersten Feldeffekttransistors (118) zugeführt wird;
einen ersten Wechselrichter (34) mit (a) einem an die zweiten Quellen/Drain-Elektroden der ersten und zweiten Feldeffekttransistoren angeschlossenen Eingang und (b) einem Ausgang zur Lieferung eines Datenausgangssignals;
und
einen zweiten Wechselrichter (36) mit (a) einem an den Ausgang des ersten Wechselrichters angeschlossenen Eingang und (b) einem an die erste Quellen/Drain-Elektrode des zweiten Feldeffekttransistors (120) angeschlossenen Ausgang.

**32.** Elektronische Schaltung nach einem der vorhergehenden Ansprüche, wobei die elektronische Schaltung Teil einer integrierten Einkreis-Schaltung ist.

**33.** Elektronische Schaltung nach einem der vorhergehenden Ansprüche, wobei die elektronische Schaltung quer über mindestens zwei integrierte Schaltungen (160) verteilt ist, die auf einem gemeinsamen Substrat (162) angebracht sind.

**34.** Elektronische Schaltung nach einem der vorhergehenden Ansprüche, bei der der Funktionsschaltkreis CMOS-(Komplementär-Metalloxid-Halbleiter), bipolar, oder BiCMOS-Komponenten umfaßt.

**35.** Elektronische Schaltung nach einem der vorhergehenden Ansprüche, bei der der Funktionsschaltkreis pegelempfindliche Zustandselemente (pegellageerfassende Elemente) (14G; 26 oder 116) umfaßt.

**36.** Elektronische Schaltung, die umfaßt:

einen Funktionsschaltkreis (14), der elektronische Funktionen durchführt, wobei spezifizierte Elemente 14G; 26 oder 116) den sychronen Zustand mit einem ersten Schaltungstaktsignal (CKD) ändern, das von einer ersten Schaltungstaktleitung (52) zu Takteingängen der spezifizierten Elemente bei einer Schaltungsfrequenz geliefert wird; und
ein Resonanzsystem (50 oder 140), das bei der Schaltungsfrequenz schwingt, wobei das Resonanzsystem in der Nähe der Grundresonanzfrequenz so betrieben wird, das ein Resonator (62) in dem Resonanzsystem überwiegend mit der Kapazität (CP1) und/oder der Induktivität, die mit der Schaltungstaktleitung oder den Takteingängen verbunden sind, in Resonanz ist,
wobei das Resonanzsystem an den Funktionsschaltkreis angeschlossen ist, um die spezifizierten Elemente im ändernden Zustand durch Helfen zur Überwindung der mit dem Funktionsschaltkreis verbundenen Kapazitäten und/ oder Induktivitäten zu unterstützen, wobei die Schwingungen des Resonanzsystems Frequenzkomponenten einschließen, die der Grundresonanzfrquenz zuzuordnen sind, und mindestens eine Resonanzfrequenz des Resonanzsystems anders als die Grundresonanzfrequenz ist.

**37.** Elektronische Schaltung nach Anspruch 36, bei der die Schwingungen des Resonanz systems Oberschwingungen mit annähernd der Grundresonanzfrequenz einschließen.

**38.** Elektronische Schaltung nach Anspruch 37, bei der die Oberschwingungen ungeradzahlige Oberschwingungen sind.

**39.** Elektronische Schaltung nach einem der Ansprüche 37 bis 40, bei der der Resonator einen selbstgetriebenen Oszillator (130) umfaßt.

**40.** Elektronische Schaltung nach einem der vorhergehenden Ansprüche, bei der die jeweilige Schaltungstaktleitung passiv zwischen den Resonator und den Funktionsschaltkreis geschaltet ist.

**41.** Elektronische Schaltung nach einem der vorhergehenden Ansprüche, bei der der Resonator umfaßt:

einen Hauptabschnitt (L1), der die Schwingungen des Resonanzsystems mit einer Frequenzkomponente im wesentlichen bei der Grundresonanzfrequenz liefert; und
einem weiteren Abschnitt (L2 und C2), der die Schwingungen des Resonanzsystems mit einer Frequenzkomponente im wesentlichen bei einer Oberschwingungs-Resonanzfrequenz oberhalb der Grundresonanzfrequenz liefert.

**42.** Elektronische Schaltung nach Anspruch 41, bei der die Oberschwingungs-Resonanzfrequenz eine ungeradzahlige Oberschwingung ist.

**43.** Elektronische Schaltung nach einem der vorhergehenden Ansprüche, bei der unter dem Resonator, einem zeitweiligen Speicherplatz (C1 oder CP2) und einer Kapazität (CP1) und/oder Induktivität, die mit der ersten Schaltungstaktleitung und den Takteingängen, die das erste Schaltungstaktsignal aufnehmen, verbunden sind, in Resonanzart Energie übertragen wird.

**44.** Elektronische Schaltung nach einem der Ansprüche 1 bis 43 zur Anwendung in einer digitalen elektronischen Schaltung, bei der sich wiederholende Impulse zur Steuerung oder Synchronisierung vorzugsweise über ein Resonanz-Ladespeichermittel Widerstands-Schaltmitteln zugeführt werden.

**45.** Elektronische Schaltung nach einem der Ansprüche 1 bis 43 zur Anwendung in einer Takttreiberschaltung mit Resonanzausgabemitteln, die ausgebildet sind, um entsprechend einer gewünschten Taktfrequenz in Resonanz zu treten.

**46.** Elektronische Schaltung nach einem der vorhergehenden Ansprüche, bei der die andere(n) Resonanzfrequenzkomponente(n) im Verhältnis zur Grundfrequenz komponente beeinflußt ist oder sind, so daß das Taktsignal an eine Rechteckwelle angenähert ist.

**Revendications**

**1.** Circuit électronique comprenant:

un système résonnant (50 ou 140) qui, en réponse à un signal d'horloge d'entrée (CKI) à une fréquence d'horloge d'entrée, oscille à une fréquence de circuit sensiblement proportionnelle à la fréquence d'horloge d'entrée pour générer un premier signal d'horloge de circuit (CKR) à la fréquence de circuit ; et
des éléments de circuit de fonction (14) qui exécutent des fonctions électroniques en synchronisation avec le signal d'horloge de circuit, les entrées d'horloge des éléments de circuit de fonction recevant le signal d'horloge de circuit à partir d'une première ligne d'horloge de circuit (52), le fonctionnement du système résonnant étant proche d'une fréquence de résonance fondamentale, de sorte qu'un résonateur (62) dans le système résonnant est largement en résonance au moins avec la capacitance (CPI) et/ou l'inductance associées à la ligne d'horloge de circuit et aux entrées d'horloge, caractérisé en ce que les oscillations du système résonnant comprennent des composantes de fréquence attribuables à la fréquence de résonance fondamentale et à au moins une fréquence de résonance du système résonnant autre que la fréquence de résonance fondamentale.

**2.** Circuit électronique selon la revendication 1, dans lequel le système résonnant comprend un condensateur non-parasite (C1) couplé entre le résonateur et une source d'une tension de référence sensiblement fixe ou d'une autre tension à une fréquence beaucoup plus faible que la fréquence de circuit, le résonateur étant couplé à la ligne d'horloge de circuit.

**3.** Circuit électronique selon la revendication 1, dans lequel le résonateur est couplé entre la ligne d'horloge de circuit et une source (128) d'une tension de référence ($V_H$) à peu près égale à la tension moyennée dans le temps du signal d'horloge de circuit.

**4.** Circuit électronique selon la revendication 3, dans lequel le système résonnant comprend un condensateur non-parasite (C1) couplé entre (a) la source de tension de référence et (b) une source d'une autre tension de référence sensiblement fixe ou d'une autre tension à une fréquence beaucoup plus faible que la fréquence de circuit.

**5.** Circuit électronique selon la revendication 1, dans lequel le système résonnant génère un second signal d'horloge de circuit (CKR) sensiblement inverse au premier signal d'horloge de circuit, une partie au moins des fonctions électroniques des éléments de circuit de fonction étant également exécutées en synchronisation avec le second signal d'horloge de circuit.

**6.** Circuit électronique selon la revendication 5, dans lequel le résonateur est couplé entre la première ligne d'horloge de circuit et une seconde ligne d'horloge de circuit (54) à partir de laquelle les secondes entrées d'horloge des éléments de circuit de fonction reçoivent le second signal d'horloge de circuit, le résonateur étant également largement en résonance avec la capacitance (CP2) et/ou l'inductance associées à la seconde ligne d'horloge de circuit et aux secondes entrées d'horloge.

**7.** Circuit électronique selon la revendication 6, dans lequel le système résonnant comprend au moins un commutateur (70) ou un condensateur (CR) couplé entre les lignes d'horloge de circuit en série avec le résonateur.

**8.** Circuit électronique selon l'une quelconque des revendications précédentes, dans lequel le résonateur comprend un dispositif inductif principal non-parasite comprenant une bobine (L1) ou un groupe de bobines (L1A et L1B) couplées les unes aux autres en série.

**9.** Circuit électronique selon la revendication 8, dans lequel le dispositif inductif principal a une inductance contrôlable variable.

**10.** Circuit électronique selon la revendication 8 ou 9, dans lequel le résonateur comprend au moins un agencement inductif-capacitif couplé en parallèle à au moins une partie du dispositif inductif principal, chaque agencement inductif-capacitif comprenant une bobine (L2) et un condensateur (C2) couplés l'un à l'autre en série.

**11.** Circuit électronique selon la revendication 8. 9 ou 10, dans lequel le résonateur comprend au moins un condensateur (CA) couplé en parallèle à une partie du dispositif inductif principal.

**12.** Circuit électronique selon la revendication 8, 9, 10 ou 11, dans lequel le résonateur comprend au moins un condensateur (CAU) couplé entre un point interne du dispositif inductif principal et une source d'une tension de référence sensiblement fixe ou d'une autre tension à une fréquence beaucoup plus faible que la fréquence de circuit.

**13.** Circuit électronique selon la revendication 8, 9, 10, 11 ou 12, dans lequel le résonateur comprend un condensateur distribué (68) couplé à des points multiples du dispositif inductif principal.

**14.** Circuit électronique selon l'une quelconque des revendications précédentes, dans lequel le système résonnant comprend des éléments de circuit de commande (60) qui ajustent la fréquence de résonance fondamentale.

**15.** Circuit électronique selon la revendication 14, dans lequel les éléments de circuit de commande ajustent la fréquence de résonance fondamentale en modifiant les valeurs d'inductance et/ou de capacitance.

**16.** Circuit électronique selon la revendication 14 ou 15, dans lequel les éléments de circuit de commande comprennent au moins un condensateur variable (CAI) dont la capacitance est ajustable en réponse à au moins un signal de commande.

**17.** Circuit électronique selon la revendication 14, 15 ou 16, dans lequel les éléments de circuit de commande sont agencés en une boucle à verrouillage de phase.

**18.** Circuit électronique selon la revendication 14 ou 15, dans lequel les éléments de circuit de commande comprennent une pluralité d'agencements de porte-condensateur couplés les uns aux autres en parallèle pour modifier, de manière contrôlable, les valeurs de capacitance en réponse à au moins un signal de commande, chaque agencement de porte-condensateur comprenant un condensateur (CT) et une porte de transmission (78) couplés l'un à l'autre en série.

**19.** Circuit électronique selon la revendication 14, 15, 16, 17 ou 18, dans lequel les éléments de circuit de commande comprennent un comparateur de phases (72 ou 100) qui compare les phases du signal d'horloge d'entrée et du premier signal d'horloge de circuit.

**20.** Circuit électronique selon l'une quelconque des revendications précédentes, dans lequel les oscillations du système résonnant atteignent localement une amplitude maximale lorsqu'elles se produisent à l'une quelconque des fréquences de résonance du système résonnant, y compris la fréquence de résonance fondamentale.

**21.** Circuit électronique selon l'une quelconque des revendications précédentes, dans lequel la fréquence de circuit est sensiblement un multiple entier de la fréquence d'entrée, de telle manière que la fréquence de résonance fondamentale est à peu près égale au même multiple entier de la fréquence d'entrée, le multiple entier comprenant un comme multiplicateur entier le plus faible.

**22.** Circuit électronique selon la revendication 21, dans lequel le système résonnant règle la fréquence de résonance fondamentale, de manière contrôlable pour qu'elle s'approche du multiple entier de la fréquence d'entrée.

**23.** Circuit électronique selon l'une quelconque des revendications précédentes, dans lequel le système résonnant comprend un circuit de pilotage (56) via lequel chaque signal d'horloge de circuit est délivré en réponse au signal d'horloge d'entrée.

**24.** Circuit électronique selon la revendication 2, dans lequel le système résonnant comprend un circuit de pilotage (56/60) sensible au signal d'horloge d'entrée pour fournir un signal de pilotage (CKD) à un noeud entre le résonateur et le condensateur.

**25.** Circuit électronique selon la revendication 23 ou 24, dans lequel le circuit de pilotage comprend :

un pré-circuit de pilotage (102 ou 104) qui génère deux signaux de commutation sensiblement en synchronisation avec le signal d'horloge d'entrée, chaque signal de commutation ayant un niveau actif et un niveau inactif, chaque signal de commutation étant à son niveau inactif uniquement lorsque l'autre signal de commutation est à son niveau actif, de telle manière qu'un seul des signaux de commutation est actif à un instant donné ; et

deux commutateurs (QN1 et QPI ou 106 et 108) couplés ensemble à une ligne de circuit de pilotage (52 ou 110) et couplés en série entre deux alimentations de tension différente, les commutateurs étant respectivement sensibles aux signaux de commutation pour autoriser le courant à circuler à travers la ligne de circuit de pilotage lorsque l'un ou l'autre signal de commutation est à son niveau actif.

**26.** Circuit électronique selon la revendication 25, dans lequel les commutateurs comprennent deux transistors à effet de champ complémentaires (QN1 et QP1) ayant des drains respectifs couplés ensemble à la ligne de circuit de pilotage, des sources respectives couplées respectivement aux alimentations en tension et des électrodes de grille respectives qui reçoivent respectivement les signaux de commutation.

**27.** Circuit électronique selon l'une quelconque des revendications précédentes, dans lequel les oscillations du système résonnant comprennent des harmoniques à peu près de la fréquence de résonance fondamentale.

**28.** Circuit électronique selon la revendication 27, dans lequel les harmoniques sont des harmoniques impairs.

**29.** Circuit électronique selon l'une quelconque des revendications précédentes, dans lequel chaque signal d'horloge de circuit présente une excursion de tension sensiblement différent du signal d'horloge d'entrée.

**30.** Circuit électronique selon l'une quelconque des revendications précédentes, dans lequel chaque signal d'horloge de circuit présente une excursion de tension sensiblement supérieur au signal d'horloge d'entrée.

**31.** Circuit électronique selon la revendication 30, dans lequel les éléments de circuit de fonction comprennent au moins un élément de circuit comprenant:

des premier et second transistors à effet de champ complémentaires ("FET") (118, 120), comportant chacun une première électrode de source/drain, une seconde électrode de source/drain et une électrode de grille couplée au résonateur (62), un signal d'entrée de données (D) étant délivré à la première électrode de source/drain du premier transistor à effet de champ (118);

un premier inverseur (34) ayant (a) une entrée couplée aux secondes électrodes de source/drain des premier et second transistors à effet de champs et (b) une sortie pour fournir un signal de sortie de données ; et

un second inverseur (36) ayant (a) une entrée couplée à la sortie du premier inverseur et (b) une sortie couplée à la première électrode de source/drain du second transistor à effet de champ (120).

**32.** Circuit électronique selon l'une quelconque des revendications précédentes, dans lequel le circuit électronique fait partie d'un circuit intégré unique.

**33.** Circuit électronique selon l'une quelconque des revendications précédentes, dans lequel le circuit électronique est réparti dans au moins deux circuits intégrés (160) montés sur un substrat commun (162).

**34.** Circuit électronique selon l'une quelconque des revendications précédentes, dans lequel les éléments de circuit de fonction comprennent des composants CMOS. bipolaires, ou BiCMOS.

**35.** Circuit électronique selon l'une quelconque des revendications précédentes, dans lequel les éléments de circuit de fonction comprennent des éléments susceptibles de changer d'état sensible au niveau (14G ; 26 ou 116).

**36.** Circuit électronique comprenant :

des éléments de circuit de fonction (14) qui exécutent des fonctions électroniques. des éléments spécifiés (14G ; 26 ou 116) des éléments de circuit de fonction changeant d'état en synchronisation avec un premier signal d'horloge de circuit (CKR) fourni à partir d'une première ligne d'horloge de circuit (52) aux entrées d'horloge des éléments spécifiés à une fréquence de circuit ; et

un système résonnant (50 ou 140) qui oscille à la fréquence de circuit, le fonctionnement du système résonnant étant proche d'une fréquence de résonance fondamentale, de sorte qu'un résonateur (62) dans le système résonnant est largement en résonance avec la capacitance (CP1) et/ou l'inductance associées à la ligne d'horloge de circuit et aux entrées d'horloge, le système résonnant étant couplé aux éléments de circuit de fonction pour assister les éléments spécifiés à changer d'état en contribuant à faire face aux capacitances et/ou aux inductances associées aux éléments de circuit de fonction, les oscillations du système résonnant comprenant des composantes de fréquence attribuables à la fréquence de résonance fondamentale et à au moins une fréquence de résonance du système résonnant autre que la fréquence de résonance fondamentale.

**37.** Circuit électronique selon la revendication 36, dans lequel les oscillations du système résonnant comprennent des harmoniques à peu près de la fréquence de résonance fondamentale.

**38.** Circuit électronique selon la revendication 37. dans lequel les harmoniques sont des harmoniques impairs.

**39.** Circuit électronique selon l'une quelconque des revendications 37 à 40, dans lequel le résonateur comprend un oscillateur auto-commandé (130).

**40.** Circuit électronique selon l'une quelconque des revendications précédentes, dans lequel chaque ligne d'horloge de circuit est connectée passivement entre le résonateur et les éléments de circuit de fonction.

**41.** Circuit électronique selon l'une quelconque des revendications précédentes, dans lequel le résonateur comprend :

une section principale (L1) qui fournit des oscillations du système résonnant avec une composante de fréquence sensiblement à la fréquence de résonance fondamentale et

une autre section (L2 et C2) qui fournit des oscillations du système résonnant avec une composante de fréquence sensiblement à une fréquence de résonance harmonique supérieure à la fréquence de résonance fondamentale.

**42.** Circuit électronique selon la revendication 41, dans lequel la fréquence de résonance harmonique est un harmonique impair.

**43.** Circuit électronique selon l'une quelconque des revendications précédentes, dans lequel l'énergie est transférée d'une manière résonante entre le résonateur, un emplacement de stockage temporaire (C1 ou CP2) et la capacitance (CP1) et/ou l'inductance associées à la première ligne d'horloge de circuit et aux entrées d'horloge qui reçoivent le premier signal d'horloge de circuit.

**44.** Circuit électronique selon l'une quelconque des revendications 1-43, destiné à être utilisé dans un circuit électronique numérique dans lequel des impulsions répétitives de commande ou de synchronisation sont délivrées, par des moyens de stockage de charge de résonance, de préférence aux moyens de commutation résistifs.

**45.** Circuit électronique selon l'une quelconque des revendications 1-43. destiné à être utilisé dans un circuit de commande d'horloge comportant des moyens de sortie résonnants adaptés pour résonner selon une fréquence d'horloge souhaitée.

**46.** Circuit électronique selon l'une quelconque des revendications précédentes, dans lequel ladite (lesdites) autre(s) composante(s) de fréquence de résonance est ou sont pondérée(s) en amplitude par rapport à la composante de fréquence de résonance fondamentale, de sorte que le signal d'horloge se rapproche d'une onde carrée.

10
10D
VHH
QP
QN
CKI
10D
10D
CKD
12
CP1
14
14F
14F
14F
14F

FIG. 1

26
D
28
32
QB2
36
QB1
30
QA1
34
QA2
40
QD2
44
QD1
38
QC1
42
QC2
46
48
Q̄
Q
16
CKI
18
20
CKD
22
CKD̄
24
CP1
CP2

FIG. 2

50
58
14
56
CKD
52
CKR
RESONATING SECTION
DRIVER
FUNCTION CIRCUITRY
CKR
CKI
CKD
54
60
CP1
FB
CONTROL CIRCUIT
CP2
RC

FIG. 3

14
14G
50
56
52
CKR
62
CP1
RESONATOR
DRIVER
14G
14G
CKI
58
54
CKR
FB
RC
60
CONTROL CIRCUIT
CP2
14G

FIG. 4

CKR
54
L1
62
52
CKR
VOLTAGE
$V_{HH}$
0
TIME
CKI
CKR
CKR
D
28
30
32
QB2
QB1
QA1
QA2
34
36
40
QD2
QD1
38
QC1
QC2
42
44
46
48
Q
Q
26
CKR
54
L1
62
52
CKR
CP1
CP2
14
52
CKR
CP1
L1
62
54
CKR
CP2
26
D
Q
Q
• • •

FIG. 5

FIG. 6

FIG. 7

FIG. 8

CONTROL CIRCUIT
60
RC
CKR
52
L1
62
54
$\overline{CKR}$
CKR
52
L2
L1
C2
62
$\overline{CKR}$
54
56
DRIVER
CKI
52
CKR
CP1
FUNCTION CIRCUITRY
L2
L1
C2
62
54
$\overline{CKR}$
CP2
14
64
50
PC
CA1
PHASE COMPARATOR
CA2
60

FIG. 9

FIG. 10

FIG. 11

1 CYCLE
CKI
$\overline{CKR}$
$V_{HH}$
CKR
$V_{HH}/2$
VOLTAGE
0
TIME

FIG. 12

52
CKR
L1
L2
L3
C2
C3
62
54
CKR

FIG. 13

56
66
VHH
QP1
P1
N1
QN1
CKI
NPI
PRE-
DRIVER
VHH
P2
QP2
N2
QN2
52
CKR
L1
L2
L3
C2
C3
CP1
62
CKR
54
CP2
FUNCTION
CIRCUITRY
14

FIG. 14

CKI
VHH
0
P1
N1
CKR
VOLTAGE
TIME

FIG. 15

52
CKR
L1B
L1
62
L1A
CA
54
CKR

FIG. 16

52
CKR
L1C
CB
L1B
L1
62
L1A
CA
54
CKR

FIG. 17

52
CKR
L1CV
CB
L1BV
L1A
CA
L1
L1BU
62
L1CU
54
CKR

FIG. 18

52
CKR
L1CV
CBV
L1BV
62
CAV
L1A
L1
CAU
L1BU
CBU
L1CU
54
CKR
52
CKR
68
62
54
CKR
MAGNITUDE OF AC CURRENT
0
0
fCKI
2fCKI
3fCKI
4fCKI
5fCKI
6fCKI
CIRCUIT CLOCK FREQUENCY fCKR

FIG. 19

FIG. 20

FIG. 21

CKR
52
70
58
62
RESONATOR
CKR
54

FIG. 22

CKR
52
CR
58
62
RESONATOR
CKR
54

FIG. 23

60
CKI
PHASE COMPARATOR
UP
DN
COUNTER
72
74
CTL
M
76
DECODER
52
CKR
DC
DC
78
78
RESONATOR
62
QNT
QPT
QNT
QPT
CP1
CT
54
CKR
CP2

FIG. 24

72
CKR
84
NS
86
88
90
UP
74
D
Q
CK
Q
COUNTER
M
CTL
PS
SH
CKI
80
82
CS
DN
CKI

FIG. 25

14
14F
14F
50
CKR
56
52
CKI
DRIVER
CP1
FB
RESON-
ATOR
14F
14F
62
58
RC
60
C1
CONTROL
CIRCUIT

FIG. 26

56
CKI
DRIVER
52
CKR
FUNCTION
CIRCUITRY
L2
L1
C2
62
100
PC
CA1
C1
CP1
14
PHASE
COMPARATOR
60

FIG. 27

1 CYCLE
CKI
$V_{HH}$
CKR
$V_{HH}/2$
VOLTAGE
0
TIME

FIG. 28

56
102
$V_{HH}$
CKI
P1
QP1
52
CKR
PRE-
DRIVER
NPI
N1
QN1
L2
L3
L1
C2
C3
FUNCTION
CIRCUITRY
62
C1
CP1
14

FIG. 29

56
104
CKI
NPI
PRE-DRIVER
PS
NS
VHH
108
106
CKD
110
112
PRIM.
L1
T1
SEC.
C1
CKR
52
FUNCTION CIRCUITRY
14
CP1
CKI
VHH
0
PS
NS
CKR
VOLTAGE
TIME
56/60
DRIVER AND CONTROL CIRCUIT
CKD
114
RESONATOR
62
58
C1
52
CKR
FUNCTION CIRCUITRY
14
CP1

FIG. 30

FIG. 31

FIG. 32

CKR
CKD
VHH
CKI
VHH/2
VOLTAGE
0
TIME
116
Q
120
36
124
44
48
QB1
QA1
QD1
QC1
D
28
34
42
46
118
122
Q
52
CKR
RESONATOR
62
CKD
CP1
114
C1
56/60
52
CKR
FUNCTION CIRCUITRY
CKI
DRIVER AND CONTROL CIRCUIT
RESONATOR
14
CKD
62
58
126
C1
CP1

FIG. 33

FIG. 34

FIG. 35

56/60
CKI
DRIVER AND CONTROL CIRCUIT
52
CKR
FUNCTION CIRCUITRY
14
RESONATOR
CP1
62
58
INTERMEDIATE POWER SUPPLY
$V_H$
C1
128

FIG. 36

130
52
CKR
R2
R1
132
62
RESONATOR
CP1
58
$\overline{CKR}$
54
CP2
FUNCTION CIRCUITRY
14

FIG. 37

140
VFO 146
150
CKD
DRIVER
CKD
RESONATING SECTION
CKR
CKR
58
52
CKR
54
CKR
FUNCTION CIRCUITRY
CP1
14
CP2
142
CKI
PHASE/ FREQUENCY COMPARATOR
144
FILTER
VC
VF
152
FREQUENCY ADJUSTER
DIVIDE- BY-N COUNTER
LF
148

FIG. 38

146
150
DRIVER
52
CKR
62
RESONATOR
58
CP1
FUNCTION CIRCUITRY
CKR
54
CP2
14
VF
CA1
CA2
152

FIG. 39

162
14
50 OR 140
CKR
52
RESONANT SYSTEM
CP1
IC
IC
IC
54
CKR
160
160
CP2

FIG. 40